(19) **Europäisches Patentamt**
**European Patent Office**
**Office européen des brevets**

(11) **EP 3 196 713 B2**

(12) # NEUE EUROPÄISCHE PATENTSCHRIFT
Nach dem Einspruchsverfahren

(45) Veröffentlichungstag und Bekanntmachung des Hinweises auf die Entscheidung über den Einspruch:
**26.06.2024   Patentblatt 2024/26**

(45) Hinweis auf die Patenterteilung:
**21.07.2021   Patentblatt 2021/29**

(21) Anmeldenummer: **16171912.5**

(22) Anmeldetag: **30.05.2016**

(51) Internationale Patentklassifikation (IPC):
***G05B 17/02*** (2006.01)

(52) Gemeinsame Patentklassifikation (CPC):
**G05B 17/02;** G05B 2219/23446

(54) **SIMULATIONSVORRICHTUNG ZUR SIMULATION**

DEVICE FOR SIMULATION

DISPOSITIF DE SIMULATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.01.2016   DE 102016100771**
**13.05.2016   DE 102016108933**

(43) Veröffentlichungstag der Anmeldung:
**26.07.2017   Patentblatt 2017/30**

(73) Patentinhaber: **dSPACE GmbH**
**33102 Paderborn (DE)**

(72) Erfinder: **Meyer, Gerrit**
**33098 Paderborn (DE)**

(74) Vertreter: **Gesthuysen Patentanwälte Partnerschaftsgesellschaft mbB Huyssenallee 68 45128 Essen (DE)**

(56) Entgegenhaltungen:
**DE-A1-102005 048 464     US-A1- 2011 133 763 US-B2- 8 587 322**

**Beschreibung**

Die Erfindung betrifft eine Simulationsvorrichtung zur Simulation einer an ein Regelungsgerät anschließbaren peripheren Schaltungsanordnung.

Aus der PCT-Druckschrift WO 2010 010022 A1 ist eine Schaltung zur Nachbildung - das heißt zur Simulation - einer elektrischen Last an einem Anschluss einer Testschaltung bekannt. Einige Bestandteile der Figur 3 der o.g. PCT-Druckschrift sind vorliegend als Figur 1c zum besseren Verständnis des Standes der Technik beigefügt. In der Druckschrift wird insbesondere eine steuerbare Spannungsquelle als vierquadrantenfähige Umschaltvorrichtung 17 mit einer internen Spannungsquelle 18 vorgeschlagen. Ein von der vierquadrantenfähigen Umschaltvorrichtung 17 zu der Testschaltung 3 fließender Strom kann insbesondere via Induktivität 14 eines Brückenquerzweigs eingekoppelt werden. Je nach Anforderungen an die Dynamik der Schaltung zur Simulation und je nach Ausprägung von Erfordernissen, eine ungewollte Überlagerung des Stromes im Brückenquerzweig mit Rippelströmen bzw. eine ungewollte-gegebenenfalls hochfrequente - Wechselstromüberlagerung des Stromes im Brückenquerzweig zumindest zu reduzieren oder zu vermeiden, könnte sich die aus der Druckschrift bekannte steuerbare Spannungsquelle 13 als nicht ausreichend für hochgradig präzise Simulationsanwendungen erweisen.

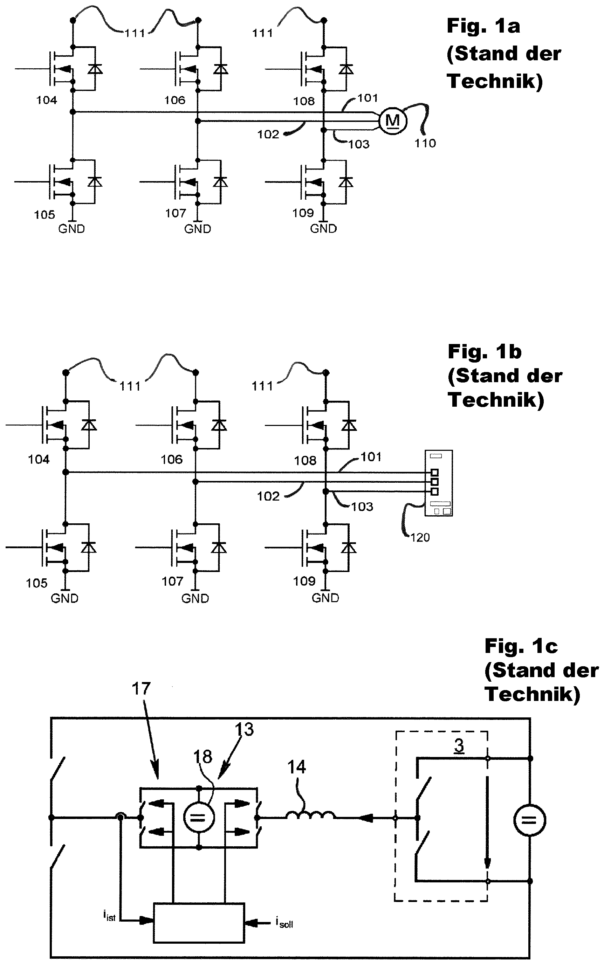

Zum allgemeinen Fachwissen gehört es, dass ein mehrphasiger - insbesondere dreiphasiger - elektrischer Verbraucher, beispielsweise ein Elektromotor 110 aus der Figur 1a, hier als ein Drei-Phasen-Elektromotor ausgestaltet, mit einer Versorgungsschaltung verbunden werden kann, wobei pro Phase beispielsweise jeweils eine zugeordnete Halbbrückenschaltung zur Stromsteuerung an der jeweiligen Phase angeschlossen werden kann. Die Figur 1a zeigt ein Beispiel aus dem Stand der Technik, wobei die drei Phasen 101, 102, 103 eines Elektromotors 110 mittels einer ersten Halbbrücke 104, 105, einer zweiten Halbbrücke 106, 107 und einer dritten Halbbrücke 108, 109 versorgt werden, wobei diese drei Halbbrücken aus Feldeffekttransistoren 104, 105, 106, 107, 108, 109, abgekürzt FETs, gebildet sind. Die Drain-Anschlüsse der FETs 104, 106, 108 sind mit einer gemeinsamen Betriebsspannung 111 verbunden. Die Source-Anschlüsse der FETs 105, 107, 109 sind mit einem gemeinsamen Referenzpotential GND verbunden. Die drei Halbbrücken aus Figur 1a sind beispielsweise in einem Regelungsgerät integriert, das den Elektromotor 110 ansteuert.

Die Figur 1b ist abgesehen davon, dass im Vergleich zu Figur 1a der Elektromotor 110 durch eine Elektromotor-Simulationsvorrichtung 120 ersetzt ist, identisch zu Figur 1a. Es ist eine aus dem Stand der Technik allgemein bekannte Herangehensweise, eine periphere Schaltungsanordnung, beispielsweise den Elektromotor 110 aus Figur 1a, durch eine Simulationsvorrichtung, beispielsweise eine Elektromotor-Simulations-vorrichtung 120 aus Figur 1b, für Testzwecke zu ersetzen. Ein häufig auftretendes Problem bekannter Elektromotor-Simulationsvorrichtungen ist, dass diese entweder nicht ausreichend genau die Realität nachbilden, oder dass die bekannten Elektromotor-Simulationsvorrichtungen nicht flexibel genug auf veränderte zu simulierende Elektromotoren umrüstbar sind oder derartige Umrüstungen sehr umfangreiche Hardware-Änderungen erfordern, die zeitraubend sind.

Für einen Test eines Steuergerätes bzw. eines Regelungsgerätes, das in einer später vorgesehenen Verwendung mit einer peripheren Schaltungsanordnung, beispielsweise mit einer elektrischen Last, möglicherweise mit einen Elektromotor, verbunden werden soll, wird häufig eine entsprechende Testumgebung - insbesondere eine Simulationsvorrichtung - eingesetzt.

Es ist bekannt, dass ein auf dem eingangs genannten technischen Gebiet tätiger Fachmann, der eine Simulationsvorrichtung zur Simulation einer an ein Regelungsgerät anschließbaren peripheren Schaltungsanordnung bereitstellen möchte, häufig auf eine Simulationsvorrichtung zurückgreift, die eine Recheneinheit umfasst, auf der ein ausführbarer Modellcode installiert ist. Der Modellcode baut auf einem mathematischen Modell der peripheren Schaltungsanordnung auf. Das mathematische Modell wird beispielsweise in einem mehrere Schritte umfassenden Verfahren, z.B. umfassend eine Programmierung, eine sogenannten Code-Generierung und einen Übersetzungsschritt, in einen auf einer Recheneinheit ausführbaren Modellcode umgewandelt. Mittels einer zyklischen Ausführung, also zyklischen Abarbeitung des Modellcodes werden in Abhängigkeit von Eingangsvariablen vordefinierte Ausgangsvariablen zyklisch berechnet, die beispielsweise für eine Bereitstellung von Spannungen und/oder Strömen zu Simulationszwecken benutzt bzw. weiterverarbeitet werden können.

Der Test unter Verwendung einer Simulationsvorrichtung kann insbesondere den Vorteil mit sich bringen, dass sich das Steuergerät bzw. das Regelungsgerät funktional überprüfen lässt, ohne dass das Steuergerät bzw. Regelungsgerät in dessen "echte" Arbeitsumgebung gebracht werden muss. Das zu testende Regelungsgerät - oft als zu testendes "Steuergerät" bezeichnet - wird in dem oben beschriebenen Kontext fachsprachlich häufig das "device under test", abgekürzt als das "DUT", genannt. Häufig wird das Regelungsgerät bzw. das DUT mit einer entsprechend eingerichteten Simulationsvorrichtung elektrisch verbunden um zu testen, ob das Regelungsgerät in gewünschter Weise reagiert, ob also das Regelungsgerät auf bestimmte - über seine Schnittstellen empfangene - Zustandsgrößen mit einer geeigneten Ausgabe von - über seine Schnittstellen ausgegebene - Ausgangsgrößen reagiert. Dazu wird die relevante Umgebung eines Regelungsgerätes ganz oder teilweise simuliert.

In allgemein bekannten Testszenarien umfasst die nachzubildende Umgebung des zu testenden Regelungsgerätes, insbesondere auch leistungselektrische Bauteile. Beispielsweise kann es für den Test eines Regelungsgerätes erforderlich sein, eine Nachbildung also eine Simulation eines Elektromotors oder einer anderen elektrischen Last bereitzustellen, die insbesondere auch eine Induktivitätssimulation umfasst. Derartige Umgebungen können prinzipiell sowohl softwareseitig als auch mittels Hardware simuliert werden. Häufig kommt für den Test eines Regelungsgerätes mit leistungselektrischen Ausgängen und/oder Eingängen eine Simulationsvorrichtung eine speziell gestaltete Hardware und eine entsprechend adaptierte Simulationssoftware zum Einsatz.

Eine Besonderheit bei einer Simulation einer induktiven Last, um bei diesem Beispiel einer simulierten elektrischen Last zu bleiben, besteht insbesondere darin, dass in der Simulation berücksichtigt werden muss, dass eine Änderung der die korrespondierende echte induktive Last durchdringende - magnetischen Flussdichte, die beispielsweise durch einen Schaltvorgang im Regelungsgerät hervorgerufen werden kann, zu einer induzierten Spannung führt. Die damit einhergehenden nichtlinearen Strom- und Spannungsverläufe, sollen in der Simulation der elektrischen Last so realitätsnah wie möglichst nachgebildet werden. Mit anderen Worten ausgedrückt, soll die in der Testphase des Regelungsgerätes verwendete Simulationsvorrichtung das in der späteren Praxisphase auftretende Verhalten einer "echten" induktiven Last möglichst gleichartig widerspiegeln.

Die bisher zur Verfügung stehenden Simulationsvorrichtungen, insbesondere die für eine sogenannte "Hardware-in-the-Loop-Simulation" - abgekürzt "HIL-Simulation" - geeigneten Simulationsvorrichtungen, mangelt es an ausreichender Skalierbarkeit bzw. Adaptierbarkeit, d.h. eine Skalierung und Adaptierung der bisherigen Simulationsvorrichtungen beispielsweise zum Zwecke einer Anpassung der Simulationsvorrichtung an unterschiedliche zu simulierende induktive Lasten, erfordert in vielen Fällen umfangreiche Hardwareänderungen. Die Probleme, die sich aus der beschriebenen unzureichenden Skalierbarkeit bzw. unzureichenden Adaptierbarkeit ergeben, sind bisher oft nur mittels Umbau- bzw. Umrüstungsarbeiten an der Simulationsvorrichtung lösbar, insbesondere dann, wenn sich die elektrotechnischen Kenngrößen der nacheinander zu simulierenden induktiven Lasten erheblich voneinander unterscheiden.

Es besteht ein Bedarf in der Industrie und in der Forschung/Entwicklung, insbesondere in der Produktentwicklung und in der Qualitätssicherung, für eine verbesserte Simulationsvorrichtung zur Simulation einer peripheren Schaltungsanordnung, beispielsweise zur Simulation einer induktiven Last.

Häufig bestehen Anforderungen an die Simulation des dynamischen Verhaltens der induktiven Last mittels eines Modellcodes derart, dass die zum Modellcode zugehörigen und zyklisch zu berechnenden Modellvariablen beispielsweise in Ausführungszeiten berechenbar sein müssen, die im Bereich von einigen Millisekunden oder sogar nur von einigen Mikrosekunden liegen. Hierbei ist mit einer Ausführungszeit die Zeitspanne gemeint, die eine Recheneinheit benötigt, um einen Simulations-Modellcode einmal abzuarbeiten. Mit anderen Worten ausgedrückt, wird der Modellcode während einer Simulation zyklisch ausgeführt, wobei bevorzugt jede Abarbeitung des Modellcodes innerhalb einer vordefinierten Ausführungszeit erfolgt und die Abarbeitung des Modellcodes im Wesentlichen solange wiederholt wird, wie die Simulation läuft. Eine modellbasierte Simulation, wie sie auf der genannten Simulationsvorrichtung stattfindet, setzt eine zyklische - also eine wiederholt ausführbare - Abarbeitung des Modellcodes auf der Recheneinheit der Simulationsvorrichtung voraus. Prinzipiell ist eine Verwendung rechnergestützter Simulationsmodelle und eine Verwendung zugehöriger ausführbarer Modellcodes bekannt, mit denen die oben genannten Ausführungszeiten für die zyklische Modellcode-Abarbeitung sichergestellt werden können, nämlich beispielsweise Simulationsmodelle, die mittels einer numerischen Entwicklungs- und Simulationsumgebung erstellt werden können. Ein Beispiel für eine Entwicklungs- und Simulationsumgebung umfassend ein graphische Programmier-Umgebung ist das Softwareprodukt SIMULINK des Unternehmens The MathWorks. Ein Beispiel für eine Erstellung eines ausführbaren Modellcodes, beispielsweise mittels des Softwareproduktes SIMULINK, ist in dem US-Patent US 9,020,798 B2 erwähnt (Anmelder des US-Patents ist wie bei der vorliegenden Erfindung die dSPACE digital signal processing and control engineering GmbH). Es kommt jedoch in der Praxis häufig nicht allein darauf an, die Modellvariablen zur Beschreibung des sich dynamisch ändernden Zustandes der induktiven Last innerhalb der vorgegebenen Ausführungszeit mittels des Modellcodes bereitzustellen, sondern es kann beispielsweise erforderlich sein, die Simulation der peripheren Schaltungsanordnung, beispielsweise die Simulation der induktiven Last, derart auszuführen, dass an den elektrischen Verbindungsstellen zwischen der Simulationsvorrichtung und dem/den Regelungsgerät/en insbesondere Spannungen und/oder Ströme bereitgestellt werden, die einen hohen Grad an Übereinstimmung mit den dynamisch veränderlichen Spannungen und/oder Strömen bei einer "echten" - also nicht simulierten - peripheren Schaltungsanordnung aufweisen. Die nicht simulierte periphere Schaltungsanordnung umfasst beispielsweise eine induktive Last.

Anders ausgedrückt ist es ein Erfordernis, dem Anwender der Simulationsvorrichtung eine solche bereitzustellen, die eingerichtet ist, um an den vorgesehenen elektrischen Anschlüssen der Simulationsvorrichtung für das Regelungsgerät entsprechende Ströme und/oder Spannungen einzustellen, die lediglich jeweils vordefinierte maximal zulässige Abweichungen von den korrespondierenden Strömen und/oder Spannungen aus einem späteren Anwendungsfall des Regelungsgerätes aufweisen.

Die Aufgabe wird hinsichtlich der Simulationsvorrichtung durch die Merkmale des Patentanspruchs 1 gelöst. Vorteilhafte Ausgestaltungen der Erfindung sind Gegenstand von abhängigen Ansprüchen.

Es sei angemerkt, dass im Rahmen der Erfindung unter einer peripheren Schaltungsanordnung prinzipiell eine beliebige - an ein Regelungsgerät anschließbare - elektrische Last zu verstehen ist, beispielsweise ein Elektromotor oder ein anderer elektromechanischer Aktor.

Einer der Vorteile der Erfindung, nämlich eine verbesserte, das heißt eine Realitäts-nahere, Simulation, werden regelmäßig in Anwendungsfällen deutlich, bei denen die zu simulierende periphere Schaltungsanordnung nicht "nur" ein Ohmscher Widerstand ist, denn die erfindungsgemäße Simulationsvorrichtung dient vorwiegend dem Zweck nichtlineare Strom- bzw. Spannungsverläufe mit wechselnden Stromrichtungen bereitzustellen, um damit beispielsweise einen Strom von einem Regelungsgerät zu einer "echten" - aber während der Simulation nicht an dem Regelungsgerät angeschlossenen - Motorwicklung oder einer anderen komplexen peripheren Schaltungsanordnung zu simulieren.

Je realitätsnaher die Simulation des elektrischen Verhaltens der peripheren Schaltungsanordnung ist desto aussagekräftiger sind die Testergebnisse, die in einer Interaktion der Simulationsvorrichtung mit dem angeschlossenen und einem Test unterworfenen Regelungsgerät entstehen. Am Beispiel des ersten Simulationsstromes dargestellt bedeutet dies, je mehr der erste Simulationsstrom übereinstimmt mit einem Strom der im späteren "echten" Betriebsmodus von dem Regelungsgerät zur "echten" peripheren Schaltungsanordnung - also beispielsweise zur "echten" Motorwicklung - fließt, desto besser lassen sich Regler-Eigenschaften des Regelungsgerätes testen und folglich im Anschluss an den Test oder zwischen mehreren Tests optimieren.

Der Modellcode ist im Rahmen der Erfindung ein auf der Recheneinheit ausführbares Computerprogramm, wobei prinzipiell unbeachtlich ist, ob der Modellcode im Zuge einer Ausführung zunächst übersetzt wird, beispielsweise mittels eines Interpreters oder ob der Modellcode bereits in einem Format vorliegt, das ohne weitere Übersetzung von der Recheneinheit ausführbar ist. Die Recheneinheit umfasst bevorzugt einen Recheneinheit-Mikroprozessor oder einem Recheneinheit-Mikrocontroller oder einen bspw. auf einem FPGA integrierten IP-Core. Eine der Aufgaben der Recheneinheit, die der Simulationsvorrichtung zugeordnet ist, besteht darin, mittels des ausführbaren Modellcodes das erste Schaltersteuersignal zu erzeugen, worauf im nachfolgenden Text noch weiter eingegangen wird.

Der erste Lastanschluss des Regelungsgeräts ist eine elektrische Schnittstelle, die von dem Regelungsgerät gebildet ist. Einer elektrischen Last wird, wenn diese an dem ersten Lastanschluss angeschlossen ist, via erstem Lastanschluss ein Strom zugeführt, wobei dieser Strom entweder in Richtung des Regelungsgeräts oder in Richtung der an dem Regelungsgerät angeschlossenen Last fließt, je nachdem welches zeitlich veränderliche elektrische Potentialgefälle sich zwischen dem ersten Lastanschluss und dem ersten Stellmittelausgang der Simulationsvorrichtung ausgebildet hat. Der erste Simulationsstrom ist derjenige elektrische Strom, der entweder von dem ersten Lastanschluss des Regelungsgerätes zu dem ersten Stellmittelausgang der Simulationsvorrichtung oder von dem ersten Stellmittelausgang der Simulationsvorrichtung zu dem ersten Lastanschluss des Regelungsgerätes fließt.

Die elektrische Last, vorliegend auch als periphere Schaltungsanordnung bezeichnet, wird für Testzwecke durch eine simulierte periphere Schaltungsanordnung, nämlich die Simulationsvorrichtung ersetzt

Das erste Stellmittel umfasst einen ersten Mehrstufen-Konverter, der bevorzugt zumindest einen ersten, einen zweiten, einen dritten, einen vierten Halbleiterschalter zur Beeinflussung des ersten Simulationsstromes aufweist. Es ist des Weiteren bevorzugt, dass während einer ablaufenden Simulation jeder der letztgenannten vier Halbleiterschalter via Steuerungs-Anschluss des jeweiligen Halbleiterschalters mit einem korrespondierenden und von dem ersten Halbleiterschaltersteuerungsmittel ausgehenden Signal beaufschlagt ist, worauf im nachfolgenden Text noch detaillierter eingegangen wird. Der erste Mehrstufen-Konverter weist einen ersten Konverter-Ausgang auf, über den zumindest ein Anteil des ersten Simulationsstromes fließt.

Der erste Stellmittelausgang gemäß der vorliegenden Lehre ist eine Schnittstelle der Simulationsvorrichtung, wobei diese Schnittstelle eine via erstem Induktivitätsbauteil hergestellte Verbindung zu dem ersten Konverter-Ausgang des ersten Mehrstufen-Konverters darstellt. An dem ersten Stellmittelausgang liegt die erste Ausgangsspannung des ersten Stellmittels an, die von dem auf der Recheneinheit ausgeführte Modellcode beeinflusst wird. Wenn eine Verbindung von dem ersten Stellmittelausgang zu dem ersten Lastanschluss des Regelungsgerätes hergestellt ist, fließt über diese Verbindung ein vom Modellcode beeinflusster Simulationsstrom in einer von dem Modellcode beeinflussten Richtung.

Bevorzugt umfasst das erste Stellmittel zumindest vier Halbleiterschalter, die jeweils mittels eines korrespondierenden ersten modifizierten Schaltersteuersignals des ersten Halbleiterschaltersteuerungsmittels in einen leitenden oder einen gesperrten Zustand versetzt werden, wobei für jeden der vier Halbleiterschalter des ersten Stellmittels ein speziell ausgestalteter Zeitverlauf der leitenden und gesperrten Zustände herbeigeführt wird. Mit anderen Worten ausgedrückt, sind die Zeitverläufe der Schaltzustände der vier Halbleiterschalter des ersten Stellmittels unterschiedlich.

Der gemäß der Erfindung vorgesehene erste Mehrstufen-Konverter, der Bestandteil des ersten Stellmittels ist, weist Halbleiterschalter auf, wobei die Halbleiterschalter vorzugsweise

- als Feldeffekttransistoren, häufig abgekürzt als "FETs", beispielsweise sogenannte Leistungs-Feld-

4

effekttransistoren, oder

- als sogenannte Siliciumcarbid-JFET-Bauelemente, abgekürzt SiC-JFETs oder
- als Bipolartransistoren oder
- als sogenannte IGBT-Bauelemente, d.h. Bipolartransitoren mit isolierter Gate-Elektrode (IGBT ist abgeleitet aus dem engl. Begriff "insulated-gate bipolar transistor) ausgestaltet sind.

Der erste Mehrstufen-Konverter ist eingerichtet, um an dessen ersten Konverter-Ausgang eine Ausgangsspannung bereitzustellen,

- deren Maximalwert kleiner oder gleich dem Wert eines dritten Versorgungspotentials ist, und
- deren Minimalwert größer oder gleich dem Wert eines ersten Versorgungspotentials ist, und die Ausgangsspannung außerdem einen Wert annehmen kann, der einem zweiten Versorgungspotential entspricht, wobei folgende Größenbeziehungen gelten:

das dritte Versorgungspotential ist größer als das zweite Versorgungspotential und das zweite Versorgungspotential ist größer als das erste Versorgungspotential. Das erste Versorgungspotential, das zweite Versorgungspotential und das dritte Versorgungspotential versorgen das erste Stellmittel und damit den ersten Mehrstufen-Konverter.

Falls der erste Mehrstufen-Konverter gemäß einer bevorzugten Ausführungsform des ersten Stellmittels vier Halbleiterschalter umfasst, so ist vorgesehen, dass mittels einer zeitlich abgestimmter Steuerung der vier Halbleiterschalter des ersten Stellmittels an dem ersten Konverter-Ausgang ein Potential einstellbar ist, welches zwischen dem dritten Versorgungspotential und dem ersten Versorgungspotential liegt.

Zum Zwecke der Bereitstellung einer erforderlichen Spannung am ersten Konverter-Ausgang sind während einer laufenden Simulation der peripheren Schaltungsanordnung die Steuerungsanschlüsse des ersten Stellmittels mit zumindest einem ersten modifizierten Schaltersteuersignal zu beaufschlagen, das auf der Berechnung mittels des Modellcodes beruht.

Während einer laufenden Simulation der peripheren Schaltungsanordnung sind bevorzugt an vier Steuerungsanschlüssen des ersten Stellmittels das erste modifizierte Schaltersteuersignal elektrisch angelegt. Das erste modifizierte Schaltersteuersignal umfasst bevorzugt vier Gate-Source-Spannungen, die bevorzugt unterschiedliche Spannungswerte aufweisen. Anders ausgedrückt ist es bevorzugt, dass jeweils eine Gate-Source-Spannung der vier Gate-Source-Spannungen an jeweils einen der bevorzugt vier Steuerungsanschlüsse des ersten Stellmittels elektrisch angelegt ist.

In einer weiteren bevorzugten Ausführungsform der Simulationsvorrichtung ist vorgesehen, dass parallel zu der zyklischen Ausführung des Modellcodes weitere vordefinierte und aus dem Regelungsgerät stammende Daten, von dem Regelungsgerät für die Recheneinheit der Simulationsvorrichtung bereitgestellt werden, und diese Daten vorgesehen sind, um bei der zyklischen Ausführung des Modellcodes berücksichtigt zu werden. Mit anderen Worten ausgedrückt, ist die letztgenannten Ausführungsform der Simulationsvorrichtung eingerichtet, um Daten des Regelungsgerätes als Eingangsvariablen bei den Berechnungen des Modellcodes zu verwenden. Eine geeignete Schnittstelle des Regelungsgerätes zur Bereitstellung der aus dem Regelungsgerät stammenden Daten zwecks Weiterleitung an die Recheneinheit der Simulationsvorrichtung ist auf der Regelungsgerät-Seite eine sogenannte Debug-Schnittstelle, beispielsweise eine standardisierte JTAG- oder Nexus-Schnittstelle.

Eine andere bevorzugte Weiterbildung der erfindungsgemäßen Simulationsvorrichtung weist neben dem ersten Stellmittel ein zweites Stellmittel und ein drittes Stellmittel auf.

In der letztgenannten Weiterbildung der Erfindung ist vorgesehen, dass das zweite Stellmittel als ein zweiter Mehrstufen-Konverter ausgestaltet ist und/oder das dritte Stellmittel als ein dritter Mehrstufen-Konverter ausgestaltet ist. Die Wortverbindung "weitere Mehrstufen-Konverter" im nachfolgenden Text fasst begrifflich zumindest den zweiten Mehrstufenkonverter und den dritten Mehrstufenkonverter zusammen, wobei damit jedoch nicht ausgedrückt werden soll, dass eine Simulationsvorrichtung, die zwei oder vier oder mehr als vier Mehrstufenkonverter aufweist, keine sinnvolle Weiterbildung der Erfindung sein kann.

Die weiteren Mehrstufen-Konverter sind bevorzugt mit dem ersten Versorgungspotential, mit dem zweiten Versorgungspotential und mit dem dritten Versorgungspotential verbunden.

Des Weiteren ist es bevorzugt, dass die weiteren Mehrstufen-Konverter, beispielsweise der zweite Mehrstufen-Konverter des zweiten Stellmittels und der Mehrstufen-Konverter des dritten Stellmittels einen im Wesentlichen gleichen oder identischen Hardware-Aufbau im Vergleich zu dem ersten Mehrstufen-Konverter des ersten Stellmittels aufweisen.

Im Rahmen der vorliegenden Lehre wird vorgeschlagen, bevorzugt den ersten Mehrstufen-Konverter und/oder die weiteren Mehrstufen-Konverter jeweils als Drei-Stufen-Konverter zu realisieren. Ein Drei-Stufen-Konverter zeichnet sich dadurch aus, dass im laufenden Betrieb an dem Drei-Stufen-Konverter drei unterschiedliche Eingangspotentiale bzw. Eingangsspannungen anliegen, wobei mittels einer entsprechenden Ansteuerung der Halbleiterschalter des Drei-Stufen-Konverters ein Ausgangpotential einstellbar ist, das prinzipiell - wenn man von Leitungs- und Übertragungsverlusten absieht - von der kleinsten Eingangsspannung über die mittlere Eingangsspannung bis zur größten Eingangsspannung des jeweiligen Drei-Stufen-Konverters reicht. Auf den Drei-Stufen-Konverter, der eine bevorzugte Ausführungsform des Mehrstufen-Konverters darstellt, wird im Rahmen der Figurenbeschreibung nachfolgend erneut eingegangen.

Prinzipiell ist es nicht nur möglich, den ersten und/oder die weiteren Mehrstufen-Konverter als Drei-Stufen-Konverter, also mit drei unterschiedlichen Versorgungspotentialen, auszugestalten, sondern alternativ ist vorsehbar, dass der oder die Mehrstufenkonverter als Vier-Stufen-Konverter oder als N-Stufen-Konverter, also mit vier oder N unterschiedlichen Versorgungspotentialen, beispielsweise mit N=4, N=5 oder N=6 oder N>6 ausgestaltet sind.

Das gemäß der erfindungsgemäßen Simulationsvorrichtung vorgesehene Induktivitätsbauteil ist bevorzugt als elektrische Spule ausgestaltet. Optional ist vorsehbar, dass die elektrische Spule mit einem Ferritkern oder Eisenkern ausgestattet ist. Des Weiteren ist ein Mittel zur Veränderung des Induktivitätswertes des Induktivitätsbauteiles vorsehbar, indem das Mittel beispielsweise eine Verschiebung eines mit der Spule wechselwirkenden Ferrit- oder Eisen-Kernes bewirkt. Es sei angemerkt, dass ein induktiver Widerstand des Induktivitätsbauteils während eines Umschaltvorganges eines der vier Halbleitereschalter des ersten Mehrstufen-Konverters beispielsweise eine - nicht vernachlässigbare - den ersten Simulationsstrom begrenzende Wirkung aufweisen kann, wobei vorzugsweise der Modellcode und/oder eine regelungstechnische Einrichtung der Simulationsvorrichtung ausgestaltet ist, um die begrenzende Wirkung zu berücksichtigen und/oder zu kompensieren. Anhand der nachfolgenden Figuren und der Figurenbeschreibung wird weiter verdeutlicht, dass während einer laufenden Simulation, eine Begrenzung oder Vergrößerung des Simulationsstromes nicht zwangsläufig mittels der Simulationsvorrichtung allein verursacht ist. Die Simulationsvorrichtung ist deshalb vorzugsweise eingerichtet, um insbesondere ein Potentialgefälle zwischen einem Potential am ersten Konverter-Ausgang und einem weiteren Potential an dem ersten Stellmittelausgang zu berücksichtigen, was in einer Weiterbildung der Erfindung mittels einer Verarbeitung der Information über die erste Ausgangsspannung des ersten Stellmittels während der zyklischen Abarbeitung des Modellcodes durch die Recheneinheit realisiert ist.

Gemäß der vorliegenden Erfindung umfasst die Simulationsvorrichtung unter anderem eine Recheneinheit zur Ausführung eines Modellcodes. Als Recheneinheit ist prinzipiell ein beliebiger Computer verwendbar, soweit sichergestellt ist, dass der Computer zumindest eine für den jeweiligen Anwendungsfall angepasste Mindest-Rechenleistung und eine angepasste Ausstattung, beispielsweise einen ausreichenden Arbeitsspeicher aufweist, wobei die Rechenleistung und die Ausstattung der Recheneinheit zudem ausreichen muss, um eine zyklische Ausführung des Modellcodes innerhalb einer vordefinierten Zykluszeit sicherzustellen. Bevorzugt ist die Recheneinheit echtzeitfähig, wobei es insbesondere bevorzugt ist, dass die Recheneinheit mit einem sogenannten Echtzeitbetriebssystem ausgestattet ist. Sowohl das Echtzeitbetriebssystem als auch der Modellcode sind besonders bevorzugt derart ausgestaltet, dass während der Ausführung des Modellcodes mittels der Recheneinheit alle notwendigen Kriterien der sogenannten "harten Echtzeit" (engl. Fachbegriff "hard real-time") erfüllt sind. Harte Echtzeit bedeutet in dem beschriebenen Kontext beispielsweise, dass die zyklische Ausführung des Modellcodes garantiert innerhalb eines vordefinierten Zeitinterfalls, nämlich einer vordefinierten maximalen Zykluszeit, erfolgt. In der letztgenannten Ausgestaltung der Recheneinheit, die harter Echtzeitfähigkeit aufweist, führt eine Überschreitung der vordefinierten maximalen Zykluszeit - falls die Überschreitung einmal auftreten sollte - zu einem Systemfehler der Recheneinheit, der beispielsweise einen Abbruch oder einen Neustart der Simulation zur Folge hat.

Die Recheneinheit weist zumindest ein Mittel zur Ausgabe des ersten Schaltersteuersignals und optional zur Ausgabe eines zweiten und/oder dritten Schaltersteuersignals auf.

Das erste Schaltersteuersignal wird im laufenden Betrieb der Simulations-vorrichtung von der Recheneinheit zur Weitergabe an ein erstes Halbleiterschaltersteuerungsmittel bereit-gestellt. Das erste Halbleiterschaltersteuerungsmittel ist vorgesehen und eingerichtet, um das erste Schaltersteuersignal in zumindest ein erstes modifiziertes Schaltersteuersignal umzuwandeln. Im laufenden Betrieb der Simulationsvorrichtung wird das erste Schaltersteuersignal in zumindest ein erstes modifiziertes Schaltersteuersignal umgewandelt, d.h. innerhalb des ersten Halbleiterschaltersteuerungsmittels erfolgt eine Signalwandlung von dem zunächst abstrakten ersten Schaltersteuersignal in das erste modifizierte Schaltersteuersignal, das zur direkten Übertragung an die Steuerungsanschlüsse der Halbleiterschalter des ersten Stellmittels vorgesehen ist.

Zwar umfasst das erste Schaltersteuersignal bereits eine Information über einen angestrebten Schaltzustand zumindest eines Halbleiterschalters des ersten Stellmittels, jedoch ist das erste Schaltersteuersignal nicht dafür vorgesehen, um direkt an einen oder mehrere Steuerungsanschlüsse der Halbleiterschalter des ersten Stellmittels angelegt zu werden, denn das erste Schaltersteuersignal wird zunächst in ein erstes modifiziertes Schaltersteuersignal, aufweisend entsprechend angepasste Signalpegel zur Steuerung der Halbleiterschalter des ersten Stellmittels, umgewandelt. Anders ausgedrückt bedeutet dies, dass die von dem ausgeführten Modellcode bereitgestellte Information über einen einzustellenden Zustand des ersten Stellmittels in dem ersten Schaltersteuersignal enthalten ist. Das erste Halbleitersteuerungsmittel ist vorgesehen und eingerichtet, um das erste Schaltersteuersignal in ein erstes modifiziertes Schaltersteuersignal umzuwandeln. Bevorzugt ist das modifizierte Schaltersteuersignal direkt an die Steuerungs-Anschlüsse des ersten Stellmittels angelegt, um den vom Modellcode jeweils in einem Berechnungszyklus berechneten einzustellenden Schaltzustand des ersten Stellmittels zu realisieren.

Das erste modifizierte Schaltersteuersignal ist an die technischen Kenngrößen der zu steuernden Halbleiterschalter, beispielsweise an deren zulässige bzw. von einem Halbleiterschalter-Hersteller spezifizierte Gate-Source-Spannungsintervalle der Halbleiterschalter, angepasst, wobei das Beispiel der angepassten Gate-Source-Spannungsintervalle insbesondere diejenigen Halbleiterschalter betrifft, die als Feldeffekttransistoren ausgestaltet sind.

Zum Zwecke eines erleichtertem Verständnisses der vorliegenden Lehre werden im weiteren Text häufig Feldeffekttransistoren als Ausführungsformen der Halbleiterschalter des ersten Stellmittels und/oder des zweiten Stellmittels und/oder des dritten Stellmittels genannt, obwohl prinzipiell auch andere Ausführungsformen der Halbleiterschalter, beispielsweise die bereits genannten "IGBT-Bauelemente", verwendbar sind. Ein Fachmann wird, soweit er Kenntnis von der vorliegenden Erfindung hat, ohne Schwierigkeiten geeignete Halbleiterschalter - beispielsweise geeignete FETs - für das bzw. für die Stellmittel der Simulationsvorrichtung unter Berücksichtigung der elektrischen Anforderungen an die Simulationsvorrichtung auswählen.

In den folgenden Textstellen in denen ein Feldeffekttransistor als Ausführungsbeispiel eines Halbleiterschalters des ersten Stellmittels, des zweiten Stellmittels und/oder des dritten Stellmittels erwähnt ist, wird ein den jeweiligen Feldeffekttransistor des ersten Stellmittels steuernde Signal, das dem ersten modifizierten Schaltersteuersignal als eine "Gate-Source-Spannung" des damit gesteuerten Feldeffekttransistors bezeichnet.

Bevorzugt umfasst das erste modifizierte Schaltersteuersignal vier Gate-Source-Spannungen zur Ansteuerung von bevorzugt vier Steuerungs-Anschlüssen des ersten Stellmittels, wobei jeweils eine Gate-Source-Spannung der vier Gate-Source-Spannungen einem korrespondierenden Steuerungs-Anschluss des ersten Stellmittels zugeordnet ist. In der bevorzugten Ausführungsform des ersten Stellmittels, bei der zumindest vier Halbleiterschalter von dem ersten Stellmittel umfasst sind, es ist bevorzugt, dass jede der vier mittels des Modellcodes gesteuerten Gate-Source-Spannungen mit jeweils einem der vier Halbleiterschalter- in dem Beispiel also mit jeweils einem der vier Feldeffekttransistoren - des ersten Stellmittels verbunden ist.

Es ist bevorzugt vorgesehen, dass per Beaufschlagung der Feldeffekttransistoren, des ersten Mehrstufen-Konverters des ersten Stellmittels mit dem ersten modifizierten Schaltersteuersignal, welches vier Gate-Source-Spannungen aufweist, ein erster dynamisch veränderbarer Simulationsstrom eingestellt wird, der insbesondere von Berechnungsergebnissen des auf der Recheneinheit ausgeführten Modellcodes beeinflusst wird.

Die Erfindung und deren weitere Vorteile werden nachfolgend unter Bezugnahme auf die Figuren näher erläutert. Hierbei sind gleichartige Teile mit identischen Bezeichnungen versehen. Die dargestellten Ausführungsformen der Erfindung sind stark schematisiert, d.h. beispielsweise, dass die vorliegenden zeichnerischen Darstellungen keine Schaltpläne mit maximalem Detailierungsgrad sind. Stattdessen unterstützen die Zeichnungen gerade mittels der Schematisierung das Verständnis des Zusammenspiels zahlreicher Erfindungsmerkmale in Kombination.

Es zeigen:

Figur 1a    eine schematische Ansicht auf eine aus dem Stand der Technik bekannte Schaltungsanordnung zur Ansteuerung eines Drei-Phasen-Elektromotors 110, wobei von insgesamt drei Halbbrücken jeweils eine Halbbrücke mit jeweils einem Phasenanschluss des Elektromotors verbunden ist;

Figur 1b    eine schematische Ansicht auf eine aus dem Stand der Technik bekannte Schaltungsanordnung aufweisend einerseits drei Halbbrücken, wie sie beispielsweise in bekannten Regelungsgeräten enthalten sind, und andererseits eine Elektromotor-Simulationsvorrichtung 120;

Figur 1c    eine Schaltung zur Nachbildung - das heißt zur Simulation - einer elektrischen Last an einem Anschluss einer Testschaltung, wie bereits aus der Druckschrift WO 2010 010022 A1 bekannt;

Figur 2    eine schematische Ansicht auf eine erste Ausführungsform einer erfindungsgemäßen Simulationsvorrichtung;

Figur 3    eine schematische Ansicht auf eine zweite Ausführungsform einer erfindungsgemäßen Simulationsvorrichtung.

Auf die Figuren 1a, 1b und 1c wurde bereits im Rahmen der Beschreibungseinleitung bei der Würdigung des Standes der Technik eingegangen. Aus diesem Grund kann auf weitere Erläuterungen zu den Figuren 1a, 1b, 1c im nachfolgenden Text verzichtet werden.

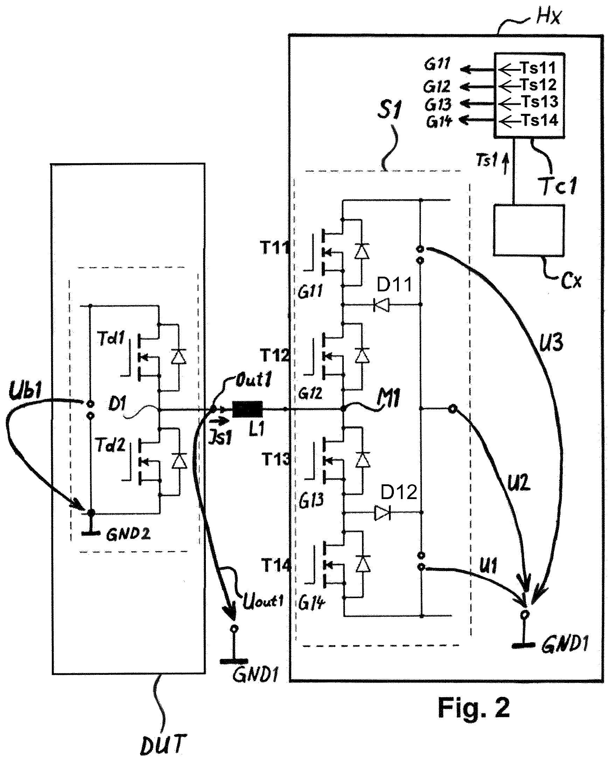

Die Abbildung der Figur 2 zeigt eine Ansicht einer ersten Ausführungsform einer Simulationsvorrichtung Hx sowie ein mit der Simulationsvorrichtung Hx elektrisch verbundenes Regelungsgerät DUT.

Das in dem Ausführungsbeispiel gemäß der Figur 2 schematisch dargestellte erste Stellmittel S1 umfasst zumindest vier Halbleiterschalter, nämlich einen ersten Halbleiterschalter T11 des ersten Stellmittels S1, einen zweiten Halbleiterschalter T12 des ersten Stellmittels S1, einen dritten Halbleiterschalter T13 des ersten Stellmittels S1 und einen vierten Halbleiterschalter T14 des ersten Stellmittels S1.

Die letztgenannten vier Halbleiterschalter T11, T12, T13, T14 sind derart untereinander und mit einem ersten Versorgungspotential U1 bzw. einem zweiten Versorgungspotential U2 bzw. einem dritten Versorgungspotential U3 verschaltet, dass das erste Stellmittel S1 einen ersten Mehrstufen-Konverter aufweist.

Besonders bevorzugt sind die zumindest vier Halbleiterschalter des ersten Stellmittels S1 als FETs ausgestaltet. Hierbei ist es bevorzugt, dass diese vier Halbleiterschalter in nachfolgend beschriebener Weise miteinander bzw. mit dem ersten Versorgungspotential U1 oder dem zweiten Versorgungspotential U2 oder dem dritten Versorgungspotential U3 verbunden sind:

> Der Drain-Anschluss des ersten Halbleiterschalters T11 ist mit dem dritten Versorgungspotential U3 verbunden;
> der Source-Anschluss des ersten Halbleiterschalters T11 ist mit dem Drain-Anschluss der zweiten Halbleiterschalters T12 verbunden;
> der Source-Anschluss des zweiten Halbleiterschalters T12 und der Drain-Anschluss des dritten Halbleiterschalters T13 und der Konverter-seitige Anschluss des ersten Induktivitätsbauteil L1 sind miteinander verbunden;
> der Source-Anschluss des dritten Halbleiterschalters T13 ist mit dem Drain-Anschluss des vierten Halbleiterschalters T14 verbunden.
> der Source-Anschluss des vierten Halbleiterschalters T14 ist mit dem ersten Versorgungspotential U1 verbunden.

Die Steuerungsanschlüsse G11, G12, G13, G14 des ersten Stellmittels S1 sind mit korrespondierenden Ausgängen eines ersten Halbleiterschaltersteuerungsmittels Tc1 verbunden.

Das in dem Ausführungsbeispiel gemäß der Figur 2 schematisch dargestellte erste Stellmittel S1 umfasst des Weiteren eine erste Diode D11 und eine zweite Diode D12. Die Kathode der ersten Diode D11 ist mit dem Source-Anschluss des ersten Halbleiterschalters T11 und mit dem Drain-Anschluss des zweiten Halbleiterschalters T12 verbunden. Die Anode der ersten Diode D11 ist an das zweite Versorgungspotential U2 anschließbar oder angeschlossen. Im laufenden Betrieb der Simulationsvorrichtung Hx liegt an der Anode der ersten Diode D11 das zweite Versorgungspotential U2 an. Die Anode der zweiten Diode D12 ist mit dem Source-Anschluss des dritten Halbleiterschalters T13 und mit dem Drain-Anschluss des vierten Halbleiterschalters T14 verbunden. Die Katode der zweiten Diode D12 ist an das zweite Versorgungs-potential anschließbar oder angeschlossen. Im laufenden Betrieb der Simulationsvorrichtung Hx liegt an der Katode der zweiten Diode D12 das zweite Versorgungspotential U2 an.

Gemäß der Figur 2 umfasst das erste Stellmittel S1 zugehörig den ersten Halbleiterschalter T11, den zweiten Halbleiterschalter T12, den dritten Halbleiterschalter T13 und den vierten Halbleiterschalter 14, wobei bevorzugt jeder dieser vier Halbleiterschalter ein sogenannter FET, also ein Feldeffekttransistor, ist. Üblicherweise sind ein sogenannter Bulk-Anschluss und der Source-Anschluss desselben FETs elektrisch verbunden. Jeweils eine in jedem der FETs inhärent vorhandene sogenannte "Body-Diode", die auch als "Inversdiode" bezeichnet wird, ist zeichnerisch dargestellt jedoch ohne ein Bezugszeichen. Wie in Figur 2 dargestellt, ist in jedem dieser vier Halbleiterschalter T11, T12, T13, T14 jeweils eine Katode einer zugehörigen Body-Diode mit einem zugehörigen Drain-Anschluss elektrisch verbunden und jeweils eine Anode einer zugehörigen Body-Diode mit einem zugehörigen Source-Anschluss verbunden. Weil für die Erfindung die Body-Dioden nicht wesentlich sind, sollen diese nicht noch detaillierter beschrieben werden.

Das erste Versorgungspotential U1, das zweite Versorgungspotential U2 das dritte Versorgungspotential U3 und eine erste Ausgangsspannung Uout1 sind jeweils bezogen auf ein erstes Referenzpotential GND1.

Gemäß einer weiteren bevorzugten Ausführungsform ist das zweite Versorgungspotential U2 gleich dem ersten Referenzpotential GND1, wobei das dritte Versorgungspotential U3 einen positiven Spannungswert und das erste Versorgungspotential einen negativen Spannungswert aufweist.

Im Zuge einer Signalwandlung des ersten Schaltersteuersignals Ts1 mittels des ersten Halbleiterschaltersteuerungsmittels Tc1 entsteht das erste modifizierte Schaltersteuersignal Ts11, Ts12, Ts13, Ts14. Gemäß der in Figur 2 dargestellten Ausführungsform der Simulationsvorrichtung Hx mit vier als Feldeffekttransistoren ausgestalteten Halbleiterschaltern T11, T12, T13, T14 ist es bevorzugt vorgesehen, dass das erste modifizierte Schaltersteuersignal zumindest vier Gate-Source-Spannungen aufweist, die zur Beaufschlagung von bevorzugt vier Steuerungs-Anschlüssen G11, G12, G13, G14 des ersten Stellmittels vorgesehen sind.

Jede der letztgenannten vier Gate-Source-Spannungen wird mit dem ersten Halbleiterschaltersteuerungsmittel Tc1 in Abhängigkeit von dem ersten Schaltersteuersignal Ts1 bevorzugt derart eingestellt, dass ein gewünschtes elektrisches Potential an dem ersten Konverter-Ausgang M1 entsteht. Ein durch das eingestellte elektrische Potential am ersten Konverter-Ausgang M1 erzeugtes Potentialgefälle zwischen dem ersten Lastanschluss D1 des Regelungsgerätes DUT und dem ersten Konverter-Ausgang M1 des ersten Stellmittels S1 führt zwangsläufig zu einem ersten Simulationsstrom Is1 entlang des Potentialgefälles.

Im Einzelnen gehören zu den letztgenannten vier Gate-Source-Spannungen:

- eine den ersten Halbleiterschalter T11 steuernde erste Gate-Source-Spannung Ts11 des ersten modifizierten Schaltersteuersignals;
- eine den zweiten Halbleiterschalter T12 steuernde zweite Gate-Source-Spannung Ts12 des ersten modifizierten Schaltersteuersignals;

- eine den dritten Halbleiterschalter T13 steuernde dritte Gate-Source-Spannung Ts13 des ersten modifizierten Schaltersteuersignals;
- eine den vierten Halbleiterschalter T14 steuernde vierte Gate-Source-Spannung Ts14 des ersten modifizierten Schaltersteuersignals.

Beispielsweise wird abhängig von einem Berechnungsergebnis des zyklisch abgearbeiten Modellcodes zyklisch ein bevorzugt digital kodiertes erstes Schaltersteuersignal Ts1 erzeugt und nachfolgend daraus ein entsprechendes zyklisch veränderliches erstes modifiziertes Schaltersteuersignal generiert, welches zugehörige zyklisch veränderliche vier Gate-Source-Spannungen des ersten modifizierten Schaltersteuersignals Ts11, Ts12, Ts13, Ts14 aufweist. Mittels der vier Gate-Source-Spannungen des ersten modifizierten Schaltersteuersignals Ts11, Ts12, Ts13, Ts14 werden beispielsweise einer oder werden beispielsweise mehrere der Halbleiterschalter T11, T12, T13, T14 des ersten Stellmittels für eine via Modellcode berechnete Zeit von einem sperrenden Zustand in einen leitenden Zustand oder umgekehrt versetzt, um damit den ersten Simulationsstrom Is1 basierend auf dem Berechnungsergebnis des Modellcodes einzustellen.

Es ist bevorzugt, dass die Recheneinheit Cx einen (nicht zeichnerisch dargestellten) Eingang zum Einlesen eines Messwertes der ersten Ausgangsspannung Uout1 und/oder eines Messwertes des ersten Simulationsstromes Is1 aufweist. Falls die Recheneinheit einen entsprechenden Eingang zum Einlesen der gemessenen ersten Ausgangsspannung Uout1 oder zum Einlesen des gemessenen ersten Simulationsstromes Is1 aufweist, ist bevorzugt vorgesehen, dass von der Recheneinheit Cx mittels des Modellcodes unter Berücksichtigung der gemessenen ersten Ausgangsspannung Uout1 oder unter Berücksichtigung des gemessenen ersten Simulationsstromes Is1 eine von der ersten Ausgangsspannung Uout1 abhängige oder eine von dem ersten Simulationsstrom Is1 abhängige Veränderung an dem ersten Schaltersteuersignal Ts1 bewirkt wird.

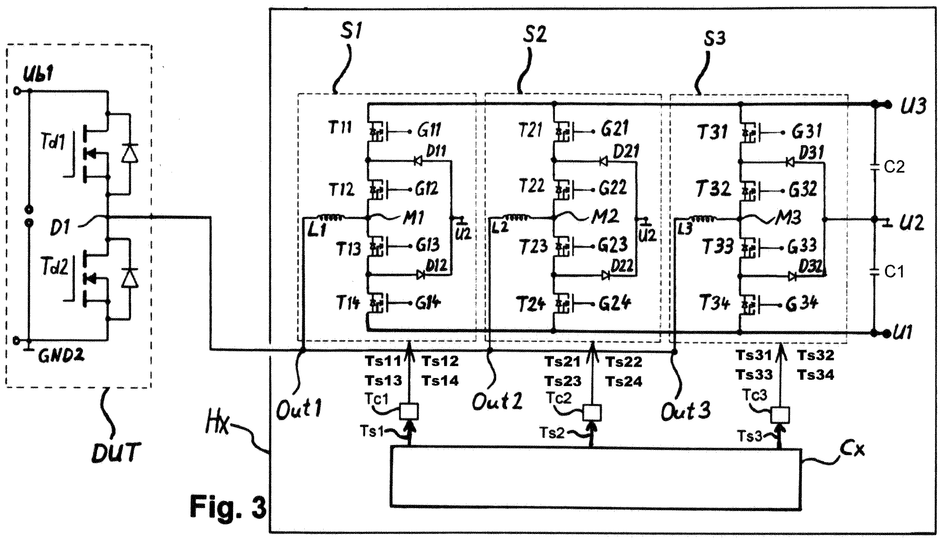

Das gemäß der Figur 3 offenbarte Ausführungsbeispiel der erfindungsgemäßen Simulationsvorrichtung Hx zeigt neben dem ersten Stellmittel S1 ein zweites Stellmittel S2 und ein drittes Stellmittel S3. Die Simulationsvorrichtung Hx aus der Figur 3 weist somit insgesamt drei Stellmittel S1, S2, S3 auf, welche hinsichtlich ihres Hardware-mäßigen Aufbaues im Wesentlichen identisch sind.

Bevorzugt sind die dargestellten Halbleiterschalter des ersten Stellmittels S1, des zweiten Stellmittels S2 und des dritten Stellmittels S3 als Feldeffekttransistoren, abgekürzt FETs, ausgestaltet.

Des Weiteren ist es bevorzugt, die in Figur 3 dargestellten drei Stellmittel S1, S2, S3 der Simulationsvorrichtung Hx mit dem ersten Versorgungspotential U1, dem zweiten Versorgungspotential U2 und dem dritten Versorgungspotential U3 zu versorgen.

Das dritte Versorgungspotential U3 ist, in dem Ausführungsbeispiel gemäß der Figur 3 verbunden mit den Drain-Anschlüssen

- des ersten Halbleiterschalters T11 des ersten Stellmittels S1,
- des ersten Halbleiterschalters T21 des zweiten Stellmittels S2,
- des ersten Halbleiterschalters T31 des dritten Stellmittels S3.

Das zweite Versorgungspotential U2 ist in dem Ausführungsbeispiel der Figur 3 via Diode/n verbunden

(A) in dem Ausführungsbeispiel der Figur 3 mit den Source-Anschlüssen

- des ersten Halbleiterschalters T11 des ersten Stellmittels S1 via Diode D11,
- des ersten Halbleiterschalters T21 des zweiten Stellmittels S2 via Diode D21,
- des ersten Halbleiterschalters T31 des dritten Stellmittels S3 via Diode D31,

wobei die Anoden der Dioden D11, D21 und D31 mit dem zweiten Versorgungspotential U2 verbunden sind,

- des dritten Halbleiterschalters T13 des ersten Stellmittels S1 via Diode D12,
- des dritten Halbleiterschalters T23 des zweiten Stellmittels S2 via Diode D22,
- des dritten Halbleiterschalters T33 des dritten Stellmittels S3 via Diode D32,

wobei die Katoden der Dioden D12, D22 und D32 mit dem zweiten Versorgungspotential U2 verbunden sind.
Das zweite Versorgungspotential U2 ist in dem Ausführungsbeispiel der Figur 3 via Diode/n verbunden

(B) mit den Drain-Anschlüssen

- des zweiten Halbleiterschalters T12 des ersten Stellmittels S1 via Diode D11,
- des zweiten Halbleiterschalters T22 des zweiten Stellmittels S2 via Diode D21,
- des zweiten Halbleiterschalters T32 des dritten Stellmittels S3 via Diode D31,
- des vierten Halbleiterschalters T14 des ersten Stellmittels S1 via Diode D12,
- des vierten Halbleiterschalters T24 des zweiten Stellmittels S2 via Diode D22,
- des vierten Halbleiterschalters T34 des dritten Stellmittels S3 via Diode D32.

Das erste Versorgungspotential U1 ist verbunden mit den Source-Anschlüssen

- des vierten Halbleiterschalters T14 des ersten Stellmittels S1,
- des vierten Halbleiterschalters T24 des zweiten Stellmittels S2,
- des vierten Halbleiterschalters T34 des dritten Stellmittels S3.

Der dem ersten Stellmittel S1 zugehörige erste Konverter-Ausgang M1, der elektrisch mit einem Konverter-seitigen Anschluss eines ersten Induktivitätsbauteil L1 elektrisch verbunden ist, bildet in den Ausführungsbeispielen gemäß der Figuren 2 und 3 außerdem einen elektrischen Verbindungspunkt mit dem Source-Anschluss des zweiten Halbleiterschalters T12 des ersten Stellmittels S1 und dem Drain-Anschluss des dritten Halbleiterschalters T13 des ersten Stellmittels S1.

Ein dem zweiten Stellmittel S2 zugehöriger zweiter Konverter-Ausgang M2, der elektrisch mit einem Konverter-seitigen Anschluss eines zweiten Induktivitätsbauteil L2 elektrisch verbunden ist, bildet in dem Ausführungsbeispiel gemäß der Figur 3 einen elektrischen Verbindungspunkt mit dem Source-Anschluss des zweiten Halbleiterschalters T22 des zweiten Stellmittels S2 und dem Drain-Anschluss des dritten Halbleiterschalters T23 des zweiten Stellmittels S2.

Ein dem dritten Stellmittel S3 zugehöriger dritter Konverter-Ausgang M3, der elektrisch mit einem Konverter-seitigen Anschluss eines dritten Induktivitätsbauteil L3 elektrisch verbunden ist, bildet in dem Ausführungsbeispiel gemäß der Figur 3 einen elektrischen Verbindungspunkt mit dem Source-Anschluss des zweiten Halbleiterschalters T32 des dritten Stellmittels S3 und dem Drain-Anschluss des dritten Halbleiterschalters T33 des dritten Stellmittels S3.

Von der Recheneinheit Cx der Ausführungsform der Simulationsvorrichtung Hx gemäß der Figur 3 werden mittels des auf der Recheneinheit Cx zyklisch ausgeführten Modellcodes in jedem Zyklus der Modellcode-Ausführung das erste Schaltersteuersignal Ts1, das zweite Schaltersteuersignal Ts2 und das dritte Schaltersteuersignal Ts3 bereitgestellt.

Wie in der Ausführungsform gemäß Figur 2 wird auch in der Ausführungsform gemäß Figur 3 das erste Schaltersteuersignal Ts1 von dem ersten Halbleiterschaltersteuerungsmittel Tc1 in das erste modifizierte Schaltersteuersignal Ts11, Ts12, Ts13, Ts14 umgewandelt.

In ähnlicher Weise ist in der Figur 3 dargestellt, dass - bezüglich einer Ausprägung eines Halbleiterschalters - unspezifische Schaltersteuersignale, nämlich das erste Schaltersteuersignal Ts1, das zweite Schaltersteuersignal Ts2 und das dritte Schaltersteuersignal Ts3 umgewandelt werden in Halbleiterschalter-spezifische, also modifizierte Schaltersteuersignale, beispielsweise Gate-Source-Spannungen für FETs, die als bevorzugte Halbleiterschalter des ersten Stellmittels S1, des zweiten Stellmittels S2 und/oder des dritten Stellmittels S3 vorgeschlagen werden.

In einer Ausführungsform der Erfindung gemäß der Figur 3 sind der erste Mehrstufen-Konverter des ersten Stellmittels S1 und der zweite Mehrstufen-Konverter des zweiten Stellmittels S2 und der dritte Mehrstufen-Konverter des dritten Stellmittels S3 mittels FETs aufgebaut, und folglich sind die Steuerungsanschlüsse des ersten Stellmittels S1, des zweiten Stellmittels S2 und des dritten Stellmittels S3 als Gate-Anschlüsse der FETs ausgestaltet.

Im Rahmen der vorliegenden Figurenbeschreibung wird insbesondere anhand von in den Figuren 2 und 3 dargestellten Ausführungsformen der erfindungsgemäßen Simulationsvorrichtung Hx aufgezeigt, dass

- nach einer Umwandlung des ersten Schaltersteuersignals Ts1 per erstem Halbleiterschaltersteuerungsmittels Tc1 in das erste modifizierte Schaltersteuersignal Ts11, Ts12, Ts13, Ts14;
- bevorzugt nach einer Umwandlung eines zweiten Schaltersteuersignals Ts2 per zweitem Halbleiterschaltersteuerungsmittels Tc2 in ein zweites modifiziertes Schaltersteuersignal Ts21, Ts22, Ts23, Ts24;
- bevorzugt nach einer Umwandlung eines dritten Schaltersteuersignals Ts3 per drittem Halbleiterschaltersteuerungsmittels Tc3 in ein drittes modifiziertes Schaltersteuersignal Ts31, Ts32, Ts33, Ts34

eine Beaufschlagung des ersten Stellmittels S1 mit dem ersten modifizierten Schaltersteuersignal Ts11, Ts12, Ts13, Ts14;

bevorzugt eine Beaufschlagung des zweiten Stellmittels S2 mit dem zweiten modifizierten Schaltersteuersignal Ts21, Ts22, Ts23, Ts24;

bevorzugt eine Beaufschlagung des dritten Stellmittels S3 mit dem dritten modifizierten Schaltersteuersignal Ts31, Ts32, Ts33, Ts34

erfolgt bzw. erfolgen.

Sind beispielsweise die Halbleiterschalter des ersten Stellmittels S1 als FETs ausgestaltet, wie in Figur 2 und in Figur 3 schematisch dargestellt, dann sind bevorzugt Gate-Source-Spannungen des ersten Stellmittels S1 folgendermaßen angeordnet:

Ein erster Steuerungs-Anschluss G11 wird beaufschlagt mit einer korrespondierenden ersten Gate-Source-Spannung Ts11,
ein zweiter Steuerungs-Anschluss G12 wird beaufschlagt mit einer korrespondierenden zweiten Gate-Source-Spannung Ts12,
ein dritter Steuerungs-Anschluss G13 wird beaufschlagt mit einer korrespondierenden dritten Gate-Source-Spannung Ts13,
ein vierter Steuerungs-Anschluss G14 wird beaufschlagt mit einer korrespondierenden vierten Gate-Source-Spannung Ts14,

wobei die letztgenannten vier Gate-Source-Spannungen bevorzugt von dem ersten modifizierten Schaltersteuersignal Ts11, Ts12, Ts13, Ts14 umfasst sind.

In der Ausführungsform gemäß der Figur 3 wird das zweite Schaltersteuersignal Ts2 von dem zweiten Halbleiterschaltersteuerungsmittel Tc2 in ein zweites modifiziertes Schaltersteuersignal Ts21, Ts22, Ts23, Ts24 umgewandelt, welches für jeden der vier dargestellten Halbleiterschalter T21, T22, T23, T24 des zweiten Stellmittels S2 jeweils eine Halbleiterschalter-spezifisches Gate-Source-Spannung aufweist.

Sind beispielsweise die Halbleiterschalter des zweiten Stellmittels S2 als FETs ausgestaltet, wie in Figur 3 schematisch dargestellt, dann sind bevorzugt Gate-Source-Spannungen des zweiten Stellmittels S2 folgendermaßen angeordnet:

Ein fünfter Steuerungs-Anschluss G21 wird beaufschlagt mit einer korrespondierenden fünften Gate-Source-Spannung Ts21,
ein sechster Steuerungs-Anschluss G22 wird beaufschlagt mit einer korrespondierenden sechsten Gate-Source-Spannung Ts22,
ein siebenter Steuerungs-Anschluss G23 wird beaufschlagt mit einer korrespondierenden siebenten Gate-Source-Spannung Ts23,
ein achter Steuerungs-Anschluss G24 wird beaufschlagt mit einer korrespondierenden achten Gate-Source-Spannung Ts24,

wobei die letztgenannten vier Gate-Source-Spannungen bevorzugt von dem zweiten modifizierten Schaltersteuersignal Ts21, Ts22, Ts23, Ts24 umfasst sind.

In der Ausführungsform gemäß der Figur 3 wird das dritte Schaltersteuersignal Ts3 von dem dritten Halbleiterschaltersteuerungsmittel Tc3 in ein drittes modifiziertes Schaltersteuersignal Ts21, Ts22, Ts23, Ts24 umgewandelt, welches für jeden der vier dargestellten Halbleiterschalter T31, T32, T33, T34 des dritten Stellmittels S3 jeweils eine Halbleiterschalter-spezifisches Gate-Source-Spannung aufweist.

Sind beispielsweise die Halbleiterschalter des dritten Stellmittels S3 als FETs ausgestaltet, wie in Figur 3 schematisch dargestellt, dann sind bevorzugt Gate-Source-Spannungen des dritten Stellmittels S3 folgendermaßen angeordnet:

Ein neunter Steuerungs-Anschluss G31 wird beaufschlagt mit einer korrespondierenden fünften Gate-Source-Spannung Ts31,
ein zehnter Steuerungs-Anschluss G32 wird beaufschlagt mit einer korrespondierenden sechsten Gate-Source-Spannung Ts32,
ein elfter Steuerungs-Anschluss G33 wird beaufschlagt mit einer korrespondierenden siebenten Gate-Source-Spannung Ts33,
ein zwölfter Steuerungs-Anschluss G34 wird beaufschlagt mit einer korrespondierenden zwölften Gate-Source-Spannung Ts34,

wobei die letztgenannten vier Gate-Source-Spannungen bevorzugt von dem dritten modifizierten Schaltersteuersignal Ts31, Ts32, Ts33, Ts34 umfasst sind.

In einem bevorzugten Ausführungsbeispiel der Simulationsvorrichtung Hx gemäß der Figur 3 ist es bevorzugt, dass

- der erste Stellmittelausgang Out1, der von dem Regelungsgerät-seitigen Anschluss des ersten Induktivitätsbauteils L1 gebildet ist, und
- der zweite Stellmittelausgang Out2, der von dem Regelungsgerät-seitigen Anschluss des zweiten Induktivitätsbauteils L2 gebildet ist, und
- der dritte Stellmittelausgang Out3, der von dem Regelungsgerät-seitigen Anschluss des zweiten Induktivitätsbauteils L2 gebildet ist.

Des Weiteren ist es in dem Ausführungsbeispiel gemäß der Figur 3 bevorzugt, dass der erste Stellmittelausgang Out1 und der zweite Stellmittelausgang Out2 und der dritten Stellmittelausgang Out3 mit einem elektrischen Verbindungsleiter elektrisch miteinander verbunden sind, und der elektrischer Verbindungsleiter vorgesehen und eingerichtet ist, um mit dem ersten Lastanschluss D1 des Regelungsgerätes DUT verbunden zu werden.

Der sich aus der Schaltungsanordnung gemäß Figur 3 ergebende weitere Vorteil besteht darin, dass die via ersten Lastanschluss D1 fließenden Ströme mittels der Simulationsvorrichtung Hx besonders präzise nachgebildet werden.

In dem Ausführungsbeispiel gemäß der Figur 3 sind bevorzugt zur Glättung des ersten Versorgungspotentials U1 und des dritten Versorgungspotentials U3 ein erster Kondensator C1 und ein zweiter Kondensator C2 an die Anschlüsse der drei letztgenannten Versorgungspotentiale U1, U2, U3 angeschlossen und zwar folgendermaßen:

Eine erste Elektrode des ersten Kondensators C1 ist mit dem ersten Versorgungspotential U1 verbunden und eine zweite Elektrode des ersten Kondensators C1 ist mit dem zweiten Versorgungspotential U2 verbunden, und eine erste Elektrode des zweiten Kondensators C2 ist mit dem zweiten Versorgungspotential U2 verbunden und eine zweite Elektrode des zweiten Kondensators C2 ist mit dem dritten Versorgungspotential U3 verbunden.

In einer bevorzugten Ausführungsform der erfindungsgemäßen Simulationsvorrichtung Hx ist vorgesehen, dass der erste Mehrstufen-Konverter zumindest einen ersten, einen zweiten, einen dritten, einen vierten Halbleiterschalter T11, T12, T13, T14 aufweist, wobei der ersten, der zweite, der dritte, der vierte Halbleiterschalter T11, T12, T13, T14 jeweils zumindest einen Steuerungs-Anschluss G11, G12, G13, G14 umfasst, und wobei an dem mit dem ersten Mehrstufen-Konverter verbundenen ersten Stellmittelausgang Out1 eine erste, von dem Modellcode beeinflusste, Ausgangsspannung Uout1 bereitstellbar ist.

Vorteilhaft an der letztgenannten Ausführungsform ist, dass mittels des ersten Mehrstufen-Konverters, dessen vier Halbleiterschalter T11, T12, T13, T14 mit dem ersten modifizierten Schaltersteuersignal Ts11, Ts12, Ts13, Ts14 beaufschlagt werden, kostengünstig realisierbar sind und außerdem hochdynamisch veränderliche, von dem Modellcode berechnete Stromänderungen des ersten Simulationsstromes Is1 bereitstellbar sind.

Gemäß einer anderen Weiterbildung der erfindungsgemäßen Simulationsvorrichtung Hx weist diese des Weiteren ein zweites Stellmittel S2 und ein drittes Stellmittel S3 auf, und wobei das zweite Stellmittel S2 als ein zweiter Mehrstufen-Konverter ausgestaltet ist und/oder wobei das dritte Stellmittel S3 als ein dritter Mehrstufen-Konverter ausgestaltet ist.

Das zweite Stellmittel S2 und das dritte Stellmittel S3 stehen in der letztgenannten Weiterbildung der Simulationsvorrichtung Hx vorteilhafterweise neben dem ersten Stellmittel S1 dafür bereit, um mittels einer elektrischen Verbindung des ersten Stellmittelausgangs Out1, des zweiten Stellmittelausgangs Out2 und des dritten Stellmittelausgangs Out3 eine Addition

Ausgangsstrom des ersten Stellmittels S1 plus
Ausgangsstrom des zweiten Stellmittels S2 plus
Ausgangsstrom des dritten Stellmittels S3

zu realisieren, wobei der sich aus der Addition ergebende Summenstrom einem ersten Lastanschluss D1 des Regelungsgerätes DUT zuführbar ist, wie dies beispielsweise mittels einer bevorzugten Simulationsvorrichtung Hx gemäß der Figur 3 vorgesehen ist. Dieser Summenstrom ist in der Regel dynamischer änderbar, als ein erster Simulationsstrom Is1, der beispielsweise gemäß der Figur 2 von einem einzigen ersten Stellmittel S1, also ohne die Addition mit einem weiteren Ausgangsstrom aus einem weiteren Stellmittel, einem ersten Lastanschluss D1 zugeführt wird.

Je dynamischer ein dem ersten Lastanschluss D1 des Regelungsgeräts DUT zuführbarer Simulationsstrom Is1 mittels der Simulationsvorrichtung Hx änderbar ist, desto realitätsnaher können Ströme, die in einer späteren "echten" Verwendung des Regelungsgerätes DUT durch dessen ersten Lastanschluss D1 fließen werden, von der Simulationsvorrichtung Hx für Testzwecke nachgebildet werden.

In einer bevorzugten Ausführungsform der erfindungsgemäßen Simulationsvorrichtung Hx ist oder sind der erste Mehrstufen-Konverter und/oder der zweite Mehrstufen-Konverter und/oder der dritte Mehrstufen-Konverter als Drei-Stufen-Konverter ausgestaltet. Überraschenderweise stellt sich eine besonders vorteilhafte Kosten-Nutzen-Relation für eine Simulationsvorrichtung Hx ein, wenn zumindest der zweite Mehrstufen-Konverter, der von dem zweiten Stellmittel S2 umfasst ist, und optional zusätzlich der dritte Mehrstufen-Konverter, der von dem dritten Stellmittel S3 umfasst ist, als Drei-Stufen-Konverter ausgestaltet sind. In die Bewertung des Nutzens fließt hierbei insbesondere die mittels der Drei-Stufen-Konverter erreichbare hohe Dynamik des zuletzt genannten Summenstroms ein.

Besonders bevorzugt ist eine Ausführungsform der Simulationsvorrichtung Hx, bei der das zweite Stellmittel S2 als ein zweiter Drei-Stufen-Konverter, aufweisend eine zweite Gruppe von zumindest vier Halbleiterschaltern T21, T22, T23, T24 und einen zweiten Stellmittelausgang Out2, ausgestaltet ist, und wobei das dritte Stellmittel S3 als ein dritter Drei-Stufen-Konverter, aufweisend eine dritte Gruppe von zumindest vier Halbleiterschaltern T31, T32, T33, T34 und einen dritten Stellmittelausgang Out3, ausgestaltet ist, und der erste Stellmittelausgang Out1 und der zweite Stellmittelausgang Out2 und der dritte Stellmittelausgang Out3 elektrisch miteinander verbunden sind.

In einer anderen Ausgestaltung der letztgenannten Weiterbildung der Simulationsvorrichtung Hx ist eine Erzeugung der Zustands-Botschaft jeweils zu einem Messungszeitpunkt einer Messung der ersten Ausgangsspannung Uout1 vorgesehen, und/oder die Zustands-Botschaft ist zu dem Messungszeitpunkt der zugehörigen Messung der ersten Ausgangsspannung Vor diesem Hintergrund besteht die Aufgabe der Erfindung darin, eine Simulationsvorrichtung zur Simulation einer an ein Regelungsgerät anschließbaren peripheren Schaltungsanordnung anzugeben, die den Stand der Technik weiterbildet. Die genannten Probleme oder Nachteile des Standes der Technik sollen bevorzugt zumindest teilweise vermieden oder reduziert werden. Das offenbarte Verfahren ist nicht Gegenstand der Erfindung Uout1 in einen Kausalzusammenhang mit einem Messwert der Messung der ersten Ausgangsspannung Uout1 gestellt.

Zusätzlich ist in einer weiteren Ausführungsform der Simulationsvorrichtung Hx vorsehbar, dass in einer der beiden letztgenannten Ausgestaltungen der Simulationsvorrichtung Hx die Zustands-Botschaft in vordefinierten zeitlichen Abständen von einem dem Regelungsgerät DUT zugehörigen Regelungsgerät-Mikroprozessor (zeichnerisch nicht dargestellt) mittels eines auf dem Regelungsgerät-Mikroprozessor ausführbaren Regelungs-Codes bereitstellbar ist.

Die letztgenannte Ausführungsform ermöglicht eine besonders frühzeitige Schaltzustands-Anpassung der Simulationsvorrichtung Hx an einen veränderlichen ersten Simulationsstrom Is1, weil die Information über die Zustandsänderungen des ersten Treiber-Transistors Td1 und des zweiten Treiber-Transistors Td2 des Regelungsgerätes DUT in einem zu dem Regelungsgerät zugehörigen Regelungsgerät-Mikroprozessor üblicherweise zuerst vorliegen, denn der Regelungs-Code wird mittels des Regelungsgerät-Mikroprozessors im dem Regelungsgerät DUT ausgeführt. In Abhängigkeit insbesondere der Berechnungsergebnisse des ausgeführten Regelungs-Codes erfolgt bevorzugt die Steuerung des ersten Treiber-Transitors Td1 und des zweiten Treiber-Transitors Td2.

Bevorzugt wird die von dem Regelungsgerät DUT zu der Simulationsvorrichtung Hx übertragene Zustands-Botschaft in der Recheneinheit Cx der Simulationvorrichtung Hx weiterverarbeitet, um auf Schaltzustände der dem ersten Stellmittel S1 zugeordneten Halbleiterschalter T11, T12, T13, T14 einen steuernden Einfluss auszuüben.

In einer weiteren Ausgestaltung der erfindungsgemäßen Simulationsvorrichtung Hx umfasst das erste Stellmittel S1 zumindest

- einen ersten Versorgungspotentialanschluss aufweisend ein erstes Versorgungspotential U1 und
- einen zweiten Versorgungspotentialanschluss aufweisend ein zweites Versorgungspotential U2 und
- einen dritten Versorgungspotentialanschluss aufweisend ein drittes Versorgungspotential U3,

wobei das dritte Versorgungspotential U3 größer ist als das zweite Versorgungspotential U2, das größer ist als das erste Versorgungspotential U1, wobei mittels einer Beaufschlagung der Steuerungs-Anschlüsse G11, G12, G13, G14 des ersten Stellmittels S1 unter Verwendung des ersten Schaltersteuersignals Ts1 die erste Ausgangsspannung Uout1 zwischen dem dritten Versorgungspotential U3 und dem ersten Versorgungspotential U1 einstellbar ist, und wobei die erste Ausgangsspannung Uout1 auf ein erstes Referenzpotential GND1 bezogen ist.

Gemäß einer zusätzlichen Ausführungsform der erfindungsgemäßen Simulationsvorrichtung Hx ist eine Zusatz-Signalverbindung (nicht zeichnerisch dargestellt) von der Recheneinheit Cx der Simulationsvorrichtung Hx zu einem von dem Regelungsgerät DUT umfassten Regelungsgerät-Mikroprozessor herstellbar oder hergestellt, um in Abhängigkeit einer via Zusatz-Signalverbindung von dem Regelungsgerät-Mikroprozessor zu der Recheneinheit Cx übertragene Information das erste und/oder das zweite und/oder das dritte Schaltersteuersignal Ts1, Ts2, Ts3 zu beeinflussen. Die Zusatz-Signalverbindung entlastet hinsichtlich einer verfügbaren Bandbreite einer optional vorgesehenen weiteren Signalverbindung, die für den Zweck eines Datenaustauschs zwischen dem Regelungsgerät DUT und der Simulationsvorrichtung Hx vorsehbar oder vorgesehen ist. Sowohl die Zusatz-Signalverbindung als auch die weitere Signalverbindung sind optional als bidirektionale Datenverbindung ausgestaltet. Als verbindende Medien können sowohl die Zusatz-Signalverbindung als auch die weitere Signalverbindung elektrische Verbindungleiter, Lichtleitkabel und/oder eine Funkverbindung bspw. WLAN aufweisen.

Soweit das erste Stellmittel S1 zumindest einen ersten Versorgungspotentialanschluss aufweisend ein erstes Versorgungspotential U1 und einen zweiten Versorgungspotentialanschluss aufweisend ein zweites Versorgungspotential U2 und einen dritten Versorgungspotentialanschluss aufweisend ein drittes Versorgungspotential U3 aufweist, ist in einer besonders bevorzugten Ausführungsform der Simulationsvorrichtung Hx vorgesehen, dass innerhalb des ersten Stellmittels S1 unter Bezugnahme auf ein erstes Referenzpotential GND1 das dritte Versorgungspotential U3 einen positiven Spannungswert aufweist, und das erste Versorgungspotential U1 einen negativen Spannungswert aufweist, und zudem folgende Größenbeziehungen gelten:

- das zweite Versorgungspotential U2 ist identisch zu dem ersten Referenzpotential GND1, also U2 = GND1 ;
- das zweite Versorgungspotential U2 weist betragsmäßig einen identischen Potentialabstand sowohl zu dem dritten Versorgungspotential U3 als auch zu dem ersten Versorgungspotential U1 auf, also

$$| \: U3 - U2 \: | = | \: U2 - U1 \: | \: ;$$

- das zweite Referenzpotential GND2 ist größer als das erste Versorgungspotential U1 und kleiner als das zweite Versorgungspotential U2, also U1 < GND2 < U2 ;
- ein viertes Versorgungspotential Ub1 ist größer als das zweite Versorgungspotential U2 und kleiner als das dritte Versorgungspotential U3, also U2 < Ub1 < U3 ;
- die Differenz, gebildet aus dem vierten Versorgungspotential Ub1 als Minuend und dem zweiten Versorgungspotential U2 als Subtrahend, ist identisch zu der Differenz, gebildet aus dem zweiten Versorgungspotential U2 als Minuend und dem zweiten Referenzpotential GND2 als Subtrahend, also

$$Ub1 - U2 = U2 - GND2 \: .$$

Die letztgenannte Ausführungsform kann vorteilhafterweise für eine besonders große Anzahl von praktisch relevanten Simulationsszenarien verwendet werden.

Überraschenderweise zeigt es sich zudem, dass aufgrund der in der letztgenannten Ausführungsform und durch die in den Gleichungen

$$|U3 - U2| = |U2 - U1| \text{ und } |Ub1 - U2 = U2 - GND2|$$

beschriebene Symmetrie ein weniger komplex aufgebauter Modellcode erforderlich ist, um die periphere Schaltungsanordnung mittels der Simulationsvorrichtung Hx zu simulieren, als es ohne die mit der letztgenannten Gleichung beschriebene Symmetrie der Fall wäre. In einer Ausführungsform kann ein elektro-chemischer Energiespeicher, bspw. ein Akkumulator, vorgesehen sein, um das vierte Versorgungspotential Ub1 bereitzustellen.

Das Verfahren zur Simulation einer an ein Regelungsgerät DUT anschließbaren peripheren Schaltungsanordnung baut auf einer Simulationsvorrichtung Hx auf, die mit dem Regelungsgerät DUT elektrisch verbunden oder elektrisch verbindbar ist, wobei die Simulationsvorrichtung Hx ein erstes Stellmittel S1 aufweist, mit dem ein von einem ersten Lastanschluss D1 des Regelungsgerätes DUT zu einem ersten Stellmittelausgang Out1 des ersten Stellmittels S1 weiterleitbarer erster Simulationsstrom Is1 beeinflusst wird. Das erste Stellmittel S1 enthält einen ersten Mehrstufen-Konverter, wobei der erste Mehrstufen-Konverter einen ersten Konverter-Ausgang M1 umfasst, wobei mit dem ersten Konverter-Ausgang M1 ein erstes Induktivitätsbauteil L1 verbunden ist, an dessen Regelungsgerät-seitigen Anschluss der erste Stellmittelausgang Out1 ausgebildet ist. Die Fließrichtung des ersten Simulationsstroms Is1 wird per Potentialänderung an dem ersten Stellmittelausgang Out1 umgekehrt. Die Simulationsvorrichtung Hx umfasst des Weiteren eine Recheneinheit Cx, die einen Modellcode ausführt, wobei mittels des auf der Recheneinheit Cx ausgeführten Modellcodes ein erstes Schaltersteuersignal Ts1 zur Weitergabe an ein erstes Halbleiterschaltersteuerungsmittel Tc1 bereitgestellt wird. Das erste Halbleiterschaltersteuerungsmittel Tc1 wandelt das erste Schaltersteuersignal Ts1 in zumindest ein erstes modifiziertes Schaltersteuersignal Ts11, Ts12, Ts13, Ts14 um, und mit zumindest dem ersten modifizierten Schaltersteuersignal Ts11, Ts12, Ts13, Ts14 wird der erste Mehrstufen-Konverter beaufschlagt. An dem mit dem ersten Mehrstufen-Konverter verbundenen ersten Stellmittelausgang Out1 wird eine erste von dem Modellcode beeinflusste Ausgangsspannung Uout1 bereitgestellt.

Die Figur 2 und die Figur 3 zeigen anhand von Ausführungsformen der erfindungsgemäßen Simulationsvorrichtung Hx jeweils an dem Verfahren bevorzugt beteiligte Komponenten, die in einem verfahrensmäßigen Wirkzusammenhang stehen.

Vorteilhaft an dem Verfahren ist insbesondere, dass der erste Mehrstufen-Konverter des ersten Stellmittels S1 mittels des ersten Halbleiterschaltersteuerungsmittels Tc1 mit besonders kurzer Verzögerung den ersten Simulationsstrom Is1 beeinflusst, sobald eine entsprechende Anforderung zur Änderung des ersten Simulationsstromes Is1 mittels des Modellcodes auf der Recheneinheit Cx berechnet wurde, und daraufhin ein entsprechendes erstes Schaltersteuersignal Ts1 von der Recheneinheit Cx an das erste Halbleiterschaltersteuerungsmittel Tc1 ausgegeben ist. Eine angestrebte Änderung des ersten Simulationsstromes Is1 mit einer möglichst geringen Verzögerung mittels der Simulationsvorrichtung Hx zu realisieren ist deshalb vorteilhaft, weil damit das Verhalten von zahlreichen peripheren Schaltungsanordnungen, die beispielsweise induktive Lasten umfassen können, in ausreichend präziser Weise nachbildbar sind.

Vorteilhaft ist außerdem, dass das Verfahren mittels einer vergleichsweise kostengünstig realisierbaren Simulationsvorrichtung Hx und einem vergleichsweise unkompliziert gestalteten - und damit kostengünstigen - Modellcode ausführbar ist.

In einer anderen Weiterbildung des Verfahrens wird der Modellcode in festen Zeitintervallen, also zeitlich konstanten Zeitintervallen, einer Anzahl Nx zyklisch mittels der Recheneinheit Cx ausgeführt und es wird oder werden innerhalb jedes der Nx festen Zeitintervalle jeweils

- das erste Schaltsteuersignal Ts1 zur Weiterleitung an das erste Halbleiterschaltersteuerungsmittel Tc1 und/oder
- das zweite Schaltsteuersignal Ts2 zur Weiterleitung an das zweite Halbleiterschaltersteuerungsmittel Tc2 und/oder
- das dritte Schaltsteuersignal Ts3 zur Weiterleitung an das dritte Halbleiterschaltersteuerungsmittel Tc3 berechnet.

Vorteilhaft an der zyklischen Ausführung des Modellcodes und der zyklischen Berechnung des ersten und/oder zweiten und/oder dritten Schaltersteuerungssignal/s/e ist, dass die Simulationsvorrichtung Hx bevorzugt in jedem Zyklus auf eine Strom- und/oder Spannungs-Änderung an zumindest einer Schnittstelle des Regelungsgerätes DUT reagiert.

Die Zykluszeiten, in denen das erste Schaltersteuersignal Ts1, das zweite Schaltersteuersignal Ts2 und/oder das dritte Schaltersteuersignal Ts3 mittels des Modellcodes berechnet wird/werden, betragen bevorzugt wenige Millisekunden oder liegen bevorzugt sogar im Bereich von wenigen Mikrosekunden. Ein Trend im Bereich der eingangs genannten HIL-Simulation besteht darin, den lauffähigen Modellcodes nicht mehr nur mittels Mikroprozessoren zu berechnen, sondern vermehrt zeitkritische Teile des Modellcodes bzw. zeitkritische lauffähige Teilmodelle auf FPGA-Bauelemente oder ähnliche Hardware-Bauelemente mit programmierbarer Logik auszulagern, womit für den betreffenden auf dem FPGA ablaufenden Teil des Modellcodes auch Zykluszeiten von weniger als einer Mikrosekunde realisierbar sind.

Gemäß einer anderen Ausführungsform des Verfahrens wird das erste Schaltersteuersignal Ts1 mittels des Modellcodes in Abhängigkeit

- eines Strommesswertes des ersten Simulationsstromes Is1 und/oder
- eines Spannungsmesswertes der ersten Ausgangsspannung Uout1 berechnet.

Ein Vorteil der letztgenannten Ausführungsform ist insbesondere, dass kein Austausch digitaler Daten zwischen dem Regelungsgerät DUT und der Simulationsvorrichtung Hx erfolgen muss, um die periphere Schaltungsanordnung zu simulieren, weil der letztgenannte Strommesswert oder der letztgenannte Spannungsmesswert in dieser Ausführungsform bevorzugt eine für die Berechnungen des Modellcodes ausreichende Information über die Schaltzustände des ersten Treiber-Transistors Td1 und/oder des zweiten Treiber-Transistors Td2 umfasst.

In einer weiteren Ausführungsform des Verfahrens wird oder werden beginnend ab einem N -ten Berechnungszyklus des Modellcodes ein Strommesswert des ersten Simulationsstromes Is1 und/oder ein Spannungsmesswert der ersten Ausgangsspannung Uout1 in dem N -ten Berechnungszyklus gemessen, und in einem (N+1) -ten Berechnungszyklus fließen der Strommesswert und/oder der Spannungsmesswert in die Berechnung des ersten Schaltersteuersignals Ts1 mittels des Modellcodes ein, um eine Abweichung des Strommesswertes des ersten Simulationsstromes Is1 und/oder um eine Abweichung des Spannungsmesswertes der ersten Ausgangsspannung Uout1 von einem korrespondierenden Modellcode-konformen Idealwert zu reduzieren, wobei der (N+1) -te Berechnungszyklus der direkt dem N -ten Berechnungszyklus nachfolgende Berechnungszyklus ist.

Ein weiterer Vorteil, der sich aus der letztgenannten Ausführungsform des Verfahrens ergibt ist der, dass zwischen einer Istwert-Feststellung bezüglich des Simulationsstromes Is1 und/oder bezüglich der ersten Ausgangsspannung Uout1 einerseits und einer entsprechenden Korrekturberechnung mittels des Modellcodes bezüglich des Simulationsstromes Is1 und/oder bezüglich der ersten Ausgangsspannung Uout1 andererseits ein maximaler Zeitversatz von einer Berechnungszyklus-Dauer entsteht, was zu einer Verbesserung der Simulationsergebnisse führt.

In einer bevorzugten Verwendung der erfindungsgemäßen Simulationsvorrichtung (Hx) wird diese als sogenannte "Hardware-in-the-loop-Simulationsvorrichtung", in Fachkreisen auch als HIL-Simulator bezeichnet, eingesetzt. Die Berechnung der Modellvariablen mittels des Modellcodes erfolgt hierbei bevorzugt in Echtzeit.

Die Vorteile der erfindungsgemäßen Simulationsvorrichtung und des Verfahrens bestehen zusammengefasst darin, dass eine verbesserte, insbesondere realitäts-nahere Simulation einer peripheren Schaltungsanordnung, die an ein Regelungsgerät anschließbar ist, ermöglicht ist. Mittels der erfindungsgemäßen Simulationsvorrichtung bzw. mittels des Verfahrens werden die eingangs benannten Nachteile des Standes der Technik zumindest teilweise abgemildert oder vermieden.

**Patentansprüche**

1. Simulationsvorrichtung (Hx) zur Simulation einer an ein Regelungsgerät (DUT) anschließbaren peripheren Schaltungsanordnung, wobei die Simulationsvorrichtung (Hx) mit dem Regelungsgerät (DUT) elektrisch verbindbar ist, und die Simulationsvorrichtung (Hx) ein erstes Stellmittel (S1) zur Beeinflussung eines von einem ersten Lastanschluss (D1) des Regelungsgerätes (DUT) zu einem ersten Stellmittelausgang (Out1) des ersten Stellmittels (S1) weiterleitbaren ersten Simulationsstromes (Is1) aufweist, und wobei das erste Stellmittel (S1) einen ersten Mehrstufen-Konverter enthält, und wobei der erste Mehrstufen-Konverter einen ersten Konverter-Ausgang (M1) umfasst, wobei der erste Konverter-Ausgang (M1) vorgesehen und eingerichtet ist, um elektrisch mit einem Konverter-seitigen Anschluss eines ersten Induktivitätsbauteil (L1) verbunden zu werden, an dessen Regelungsgerät-seitigen Anschluss der erste Stellmittelausgang (Out1) ausgebildet ist, und wobei die Fließrichtung des ersten Simulationsstroms (Is1) umkehrbar ist, und die Simulationsvorrichtung (Hx) des Weiteren eine Recheneinheit (Cx) zur Ausführung eines Modellcodes umfasst, wobei mittels des auf der Recheneinheit (Cx) gespeicherten und ausführbaren Modellcodes ein erstes Schaltersteuersignal (Ts1) zur Weitergabe an ein erstes Halbleiterschaltersteuerungsmittel (Tc1) bereitstellbar ist, und wobei das erste Halbleiterschaltersteuerungsmittel (Tc1) vorgesehen und eingerichtet ist, um das erste Schaltersteuersignal (Ts1) in zumindest ein erstes modifiziertes Schaltersteuersignal (Ts11, Ts12, Ts13, Ts14) umzuwandeln und mit zumindest dem ersten modifizierten Schaltersteuersignal (Ts11, Ts12, Ts13, Ts14) den ersten Mehrstufen-Konverter zu beaufschlagen, wobei das erste Stellmittel (S1) zumindest

   - einen ersten Versorgungspotentialanschluss aufweisend ein erstes Versorgungspotential (U1) und
   - einen zweiten Versorgungspotentialanschluss aufweisend ein zweites Versorgungspotential (U2) und
   - einen dritten Versorgungspotentialanschluss aufweisend ein drittes Versorgungspotential (U3) umfasst,
   wobei das dritte Versorgungspotential (U3) größer ist als das zweite Versorgungspotential (U2) und wobei das zweite Versorgungspotential (U2) größer ist als das erste Versorgungspotential (U1), wobei mittels einer Beaufschlagung der Steuerungs-Anschlüsse (G11, G12, G13, G14) des ersten Stellmittels (S1) unter Verwendung des ersten Schaltersteuersignals (Ts1) die erste Ausgangsspannung (Uout1) zwischen dem dritten Versorgungspotential (U3) und dem ersten Versorgungspotential (U1) einstellbar ist, und wobei die erste Ausgangsspannung (Uout1) auf ein erstes Referenzpotential (GND1) bezogen ist und

wobei während einer zyklischen Ausführung des Modellcodes auf der Recheneinheit (Cx) von dem Modellcode in vordefinierten Zeitabständen vorgesehen ist, eine von dem Regelungsgerät (DUT) bereitgestellte Zustands-Botschaft, enthaltend eine Information, die eine bevorstehende oder eine vollzogene Zustandsänderung eines ersten Treiber-Transistors (Td1) des Regelungsgerätes (DUT) oder eine bevorstehende oder eine vollzogene Zustandsänderung eines zweiten Treiber-Transistors (Td2) des Regelungsgerätes (DUT) widerspiegelt, zur Beeinflussung zumindest des ersten Stellmittels (S1) zu verarbeiten.

2. Simulationsvorrichtung (Hx) nach Anspruch 1, **dadurch gekennzeichnet, dass** der erste Mehrstufen-Konverter zumindest einen ersten, einen zweiten, einen dritten, einen vierten Halbleiterschalter (T 11, T12, T13, T14) aufweist, wobei der ersten, der zweite, der dritte, der vierte Halbleiterschalter (T11, T12, T13, T14) jeweils zumindest einen Steuerungs-Anschluss (G11, G12, G13, G14) umfasst, und wobei an dem mit dem ersten Mehrstufen-Konverter verbundenen ersten Stellmittelausgang (Out1) eine erste, von dem Modellcode beeinflusste, Ausgangsspannung (Uout1) bereitstellbar ist.

3. Simulationsvorrichtung (Hx) nach Anspruch 1 oder Anspruch 2, **dadurch gekennzeichnet, dass** die Simulationsvorrichtung (Hx) des Weiteren ein zweites Stellmittel (S2) und ein drittes Stellmittel (S3) aufweist, und wobei das zweite Stellmittel (S2) als ein zweiter Mehrstufen-Konverter ausgestaltet ist und/oder wobei das dritte Stellmittel (S3) als ein dritter Mehrstufen-Konverter ausgestaltet ist.

4. Simulationsvorrichtung (Hx) nach einem der Ansprüche 1 bis 3, **dadurch gekennzeichnet, dass** der erste Mehrstufen-Konverter und/oder der zweite Mehrstufen-Konverter und/oder der dritte Mehrstufen-Konverter als Drei-Stufen-Konverter ausgestaltet ist oder sind.

5. Simulationsvorrichtung (Hx) nach einem der Ansprüche 3 oder 4, **dadurch gekennzeichnet, dass** das zweite Stellmittel (S2) als ein zweiter Drei-Stufen-Konverter, aufweisend eine zweite Gruppe von zumindest vier Halbleiterschaltern (T21, T22, T23, T24) und einen zweiten Stellmittelausgang (Out2), ausgestaltet ist, und wobei das dritte Stellmittel (S3) als ein dritter Drei-Stufen-Konverter, aufweisend eine dritte Gruppe von zumindest vier Halbleiterschaltern (T31, T32, T33, T34) und einen dritten Stellmittelausgang (Out3), ausgestaltet ist, und der erste Stellmittelausgang (Out1) und der zweite Stellmittelausgang (Out2) und der dritte Stellmittelausgang (Out3) elektrisch miteinander verbunden sind.

6. Simulationsvorrichtung (Hx) nach einem der Ansprüche 1 bis 5, **dadurch gekennzeichnet, dass** eine Erzeugung der Zustands-Botschaft jeweils zu einem Messungszeitpunkt einer Messung der ersten Ausgangsspannung (Uout1) vorgesehen ist und/oder die Zustands-Botschaft zu dem Messungszeitpunkt der zugehörigen Messung der ersten Ausgangsspannung (Uout1) in einem Kausalzusammenhang mit einem Messwert der Messung der ersten Ausgangsspannung (Uout1) gestellt ist.

7. Simulationsvorrichtung (Hx) nach einem der Ansprüche 1 bis 6, **dadurch gekennzeichnet, dass** die Zustands-Botschaft in vordefinierten zeitlichen Abständen von einem dem Regelungsgerät (DUT) zugehörigen Regelungsgerät-Mikroprozessor mittels eines auf dem Regelungsgerät-Mikroprozessor ausführbaren Regelungs-Codes bereitstellbar ist.

8. Simulationsvorrichtung (Hx) nach einem der Ansprüche 1 bis 7, **dadurch gekennzeichnet, dass** eine Zusatz-Signalverbindung von der Recheneinheit (Cx) der Simulationsvorrichtung (Hx) zu einem von dem Regelungsgerät (DUT) umfassten Regelungsgerät-Mikroprozessor herstellbar oder hergestellt ist, um in Abhängigkeit einer via Zusatz-Signalverbindung von dem Regelungsgerät-Mikroprozessor zu der Recheneinheit (Cx) übertragenen Information das erste und/oder das zweite und/oder das dritte Schaltersteuersignal (Ts1, Ts2, Ts3) zu beeinflussen.

9. Simulationsvorrichtung (Hx) nach Anspruch 8, **dadurch gekennzeichnet, dass** innerhalb des ersten Stellmittels (S1) unter Bezugnahme auf das erste Referenzpotential (GND1) das dritte Versorgungspotential (U3) einen positiven Spannungswert aufweist, und das erste Versorgungspotential (U1) einen negativen Spannungswert aufweist, und zudem folgende Größenbeziehungen gelten:

- das zweite Versorgungspotential (U2) ist identisch zu dem ersten Referenzpotential (GND1), also U2 = GND1 ;
- das zweite Versorgungspotential (U2) weist betragsmäßig einen identischen Potentialabstand sowohl zu dem dritten Versorgungspotential (U3) als auch zu dem ersten Versorgungspotential (U1) auf, also

$$|(U3 - U2)| = |(U2 - U1)| \; ;$$

- das zweite Referenzpotential (GND2) ist größer als das erste Versorgungspotential (U1) und kleiner als das zweite Versorgungspotential (U2), also U1 < GND2 < U2 ;
- das vierte Versorgungspotential (Ub1) ist größer als das zweite Versorgungspotential (U2) und kleiner als das dritte Versorgungspotential (U3), also U2 < Ub1 < U3 ;
- die Differenz, gebildet aus dem vierten Versorgungspotential Ub1 als Minuend und dem zweiten Versorgungspotential U2 als Subtrahend, ist identisch zu der Differenz, gebildet aus dem zweiten Versorgungspotential U2 als Minuend und dem zweiten Referenzpotential GN2 als Subtrahend, also Ub1 - U2 = U2 - GND2.

**Claims**

1. A simulation device (Hx) for simulating a peripheral circuit configuration for connecting to a control device (DUT), the simulation device (Hx) having the control device (DUT) can be connected electrically and the simulation device (Hx) comprising a first adjuster (S1) for influencing a first simulation current (Is1) for forwarding from a first load connection (D1) of the control device (DUT) to a first adjuster output (Out1) of the first adjuster (S1), and the first adjuster (S1) comprising a first multistage converter, and the first multistage converter comprising a first converter output (M1), the first converter output (M1) being provided and equipped for being electrically connected to a connection on the converter side of a first inductivity component (L1), the first adjuster output (Out1) being implemented at the connection thereof on the control device side, and the flow direction of the first simulation current (Is1) being reversible, and the simulation device (Hx) further comprising a processing unit (Cx) for executing a model code, a first switch control signal (Ts1) being able to be provided by means of the model code saved and executable on the processing unit (Cx) for forwarding to a first semiconductor switch control means (Tc1), and the first semiconductor switch control means (Tc1) being provided and equipped for converting the first switch control signal (Ts1) into at least one first modified switch control signal (Ts11, Ts12, Ts13, Ts14) and for applying at least the first modified switch control signal (Ts11, Ts12, Ts13, Ts14) to the first multistage converter, the first adjuster (S1) comprising at least

    - a first supply potential connection comprising a first supply potential (U1), and
    - a second supply potential connection comprising a second supply potential (U2), and
    - a third supply potential connection comprising a third supply potential (U3),
    the third supply potential (U3) being greater than the second supply potential (U2), and the second supply potential (U2) being greater than the first supply potential (U1), the first output voltage (Uout1) being adjustable between the third supply potential (U3) and the first supply potential (U1) by means of loading the control connections (G11, G12, G13, G14) of the first adjuster (S1) using the first switch control signal (Ts1), and the first output voltage (Uout1) being referenced to a first reference potential (GND1) and that it is provided that a state message provided by the control device (DUT) and comprising information reflecting an imminent or completed change in state of a first driver transistor (Td1) of the control device (DUT) or an imminent or completed change in state of a second driver transistor (Td2) of the control device (DUT) is processed by the model code for influencing at least the first adjuster (S1) while cyclically executing the model code at predefined time intervals on the processing unit (Cx) .

2. The simulation device (Hx) according to claim 1, **characterized in that** the first multistage converter comprises at least one first, one second, one third, and one fourth semiconductor switch (T11, T12, T13, T14), wherein the first, the second, the third, the fourth semiconductor switch (T11, T12, T13, T14) each comprise at least one control connection (G11, G12, G13, G14), and wherein a first output voltage (Uout1) influenced by the model code can be provided at the first adjuster output (Out1) connected to the first multistage converter.

3. The simulation device (Hx) according to claim 1 or claim 2, **characterized in that** the simulation device (Hx) further comprises a second adjuster (S2) and a third adjuster (S3), and wherein the second adjuster (S2) is implemented as a second multistage converter and/or wherein the third adjuster (S3) is implemented as a third multistage converter.

4. The simulation device (Hx) according to any one of the claims 1 through 3, **characterized in that** the first multistage converter and/or the second multistage converter and/or the third multistage converter is or are implemented as three-stage converters.

5. The simulation device (Hx) according to any one of the claims 3 or 4, **characterized in that** the second adjuster (S2) is implemented as a second three-stage converter comprising a second group of four or more semiconductor switches (T21, T22, T23, T24) and a second adjuster output (Out2), and wherein the third adjuster (S3) is implemented as a third three-stage converter comprising a third group of four or more semiconductor switches (T31, T32, T33, T34) and a third adjuster output (Out3), and the first adjuster output (Out1) and the second adjuster output (Out2) and the third adjuster output (Out3) are electrically connected to each other.

6. The simulation device (Hx) according to one of the claims 1 to 5, **characterized in that** it is provided that the state message is generated at each point in time of a measurement of the first output voltage (Uout1) and/or the state message is placed in a causal relationship to a measurement value of the measurement of the first output voltage (Uout1) at the point in time of the associated measurement of the first output voltage (Uout1).

7. The simulation device (Hx) according to one of the claims 1 to 6, **characterized in that** the state message can be provided at predefined time intervals by a control device microprocessor associated with the control device (DUT) by means of a control code for executing on the control device microprocessor.

8. The simulation device (Hx) according to any one of the claims 1 through 7, **characterized in that** an additional signal connected can be or is connected from the processing unit (Cx) of the simulation device (Hx) to a control device microprocessor comprised by the control device (DUT) in order to influence the first and/or the second and/or the third switch signal (Ts1, Ts2, Ts3) as a function of information transmitted via the additional signal connection from the control device microprocessor to the processing unit (Cx).

9. The simulation device (Hx) according to claim 8, **characterized in that** the third supply potential (U3) has a positive voltage value and the first supply potential (U1) has a negative voltage value with reference to the first reference potential (GND1) within the first adjuster (S1), and that the following relationships apply among parameters:

- the second supply potential (U2) is identical to the first reference potential (GND1), that is, U2 = GND1;
- the second supply potential (U2) has an identical absolute difference in potential from the third supply potential (U3) and from the first supply voltage (U1), that is,

$$|(U3 - U2)| = |(U2 - U1)|;$$

- the second reference potential (GND2) is greater than the first supply potential (U1) and less than the second supply potential (U2), that is, U1 < GND2 < U2;
- the fourth supply potential (Ub1) is greater than the second supply potential (U2) and less than the third supply potential (U3), that is, U2 < Ub1 < U3;
- the difference between the fourth supply potential Ub1 as the minuend and the second supply potential U2 as the subtrahend is identical to the difference between the second supply potential U2 as the minuend and the second reference potential GND2 as the subtrahend, that is, Ub1 - U2 = U2 - GND2.

**Revendications**

1. Dispositif de simulation (Hx) pour la simulation d'un agencement de circuit périphérique pouvant être raccordé à un appareil de régulation (DUT), dans lequel le dispositif de simulation (Hx) peut être relié électriquement à l'appareil de régulation (DUT), et le dispositif de simulation (Hx) comporte un premier moyen de réglage (S1) pour influencer un premier courant de simulation (Is1) qui peut être retransmis d'un premier raccord de charge (D1) de l'appareil de régulation (DUT) vers une première sortie (Out1) de moyen de réglage du premier moyen de réglage (S1), et dans lequel le premier moyen de réglage (S1) comprend un premier convertisseur à plusieurs étages, et dans lequel le premier convertisseur à plusieurs étages comprend une première sortie (M1) de convertisseur, la première sortie (M1) de convertisseur étant prévue et configurée pour être connectée électriquement à une borne côté convertisseur d'un premier composant d'inductance (L1) à la borne côté appareil de régulation duquel est formée la première sortie (Out1) de moyen de réglage, et dans lequel le sens de circulation du premier courant de simulation (Is1) est réversible, et le dispositif de simulation (Hx) comprend en outre une unité de calcul (Cx) pour exécuter un code de modèle, dans lequel, au moyen du code de modèle mémorisé et exécutable sur l'unité de calcul (Cx), un premier signal de commande de commutation (Ts1) destiné à être retransmis à un premier moyen de commande de commutation à semiconducteurs (Tc1) est fourni, et dans lequel le premier moyen de commande de commutation à semiconducteurs (Tc1) est prévu et configuré pour convertir le premier signal de commande de commutation (Ts1) en au moins un premier signal de commande de commutation modifié (Ts11, Ts12, Ts13, Ts14) et appliquer au moins le premier signal de commande de commutation modifié (Ts11, Ts12, Ts13, Ts14) au premier convertisseur à plusieurs étages, le premier moyen de réglage (S1) comprenant au moins

- une première borne de potentiel d'alimentation comportant un premier potentiel d'alimentation (U1), et
- une deuxième borne de potentiel d'alimentation comportant un deuxième potentiel d'alimentation (U2) et

- une troisième borne de potentiel d'alimentation comportant un troisième potentiel d'alimentation (U2),

sachant que le troisième potentiel d'alimentation (U3) est supérieur au deuxième potentiel d'alimentation (U2) et le deuxième potentiel d'alimentation (U2) est supérieur au premier potentiel d'alimentation (U1), sachant que la première tension de sortie (Uout1) est réglable entre le troisième potentiel d'alimentation (U3) et le premier potentiel d'alimentation (U1) par une mise sous tension des bornes de commande (G11, G12, G13, G14) du premier moyen de réglage (S1) par utilisation du premier signal de commande de commutation (Ts1), et sachant que la première tension de sortie (Uout1) se rapporte à un premier potentiel de référence (GND1) et que pendant une exécution cyclique du code de modèle sur l'unité de calcul (Cx), il est prévu par le code de modèle, à des intervalles de temps prédéfinis, de traiter un message d'état fourni par l'appareil de régulation (DUT), comprenant des informations qui reflètent un changement d'état imminent ou accompli d'un premier transistor d'attaque (Td1) de l'appareil de régulation (DUT) ou un changement d'état imminent ou accompli d'un deuxième transistor d'attaque (Td2) de l'appareil de régulation (DUT), afin d'influencer au moins le premier moyen de réglage (S1).

2. Dispositif de simulation (Hx) selon la revendication 1, **caractérisé en ce que** le premier convertisseur à plusieurs étages comprend au moins un premier, un deuxième, un troisième, un quatrième interrupteur à semiconducteurs (T11, T12, T13, T14), dans lequel le premier, le deuxième, le troisième, le quatrième interrupteur à semiconducteurs (T11, T12, T13, T14) comprennent chacun au moins une borne de commande (G11, G12, G13, G14), et dans lequel une première tension de sortie (Uout1) influencée par le code de modèle peut être fournie à la première sortie (Out1) de moyen de réglage connectée au premier convertisseur à plusieurs étages.

3. Dispositif de simulation (Hx) selon la revendication 1 ou la revendication 2, **caractérisé en ce que** le dispositif de simulation (Hx) comprend en outre un deuxième moyen de réglage (S2) et un troisième moyen de réglage (S3), et dans lequel le deuxième moyen de réglage (S2) se présente sous la forme d'un deuxième convertisseur à plusieurs étages et/ou dans lequel le troisième moyen de réglage (S3) se présente sous la forme d'un troisième convertisseur à plusieurs étages.

4. Dispositif de simulation (Hx) selon l'une quelconque des revendications 1 à 3, **caractérisé en ce que** le premier convertisseur à plusieurs étages et/ou le deuxième convertisseur à plusieurs étages et/ou le troisième convertisseur à plusieurs étages se présente ou se présentent sous la forme d'un ou de convertisseur(s) à trois étages.

5. Dispositif de simulation (Hx) selon l'une quelconque des revendications 3 et 4, **caractérisé en ce que** le deuxième moyen de réglage (S2) se présente sous la forme d'un deuxième convertisseur à trois étages, comprenant un deuxième groupe d'au moins quatre interrupteurs à semiconducteurs (T21, T22, T23, T24) et une deuxième sortie (Out2) de moyen de réglage, et dans lequel le troisième moyen de réglage (S3) se présente sous la forme d'un troisième convertisseur à trois étages, comprenant un troisième groupe d'au moins quatre interrupteurs à semiconducteurs (T31, T32, T33, T34) et une troisième sortie (Out3) de moyen de réglage, et la première sortie (Out1) de moyen de réglage et la deuxième sortie (Out2) de moyen de réglage et la troisième sortie (Out3) de moyen de réglage sont reliées électriquement entre elles.

6. Dispositif de simulation (Hx) selon l'une quelconque des revendications 1 à 5, **caractérisé en ce qu'**une génération du message d'état est prévue dans chaque cas à un instant de mesure d'une mesure de la première tension de sortie (Uout1) et/ou le message d'état est placé dans une relation de cause à effet avec une valeur mesurée de la mesure de la première tension de sortie (Uout1) à l'instant de mesure de la mesure associée de la première tension de sortie (Uout1) .

7. Dispositif de simulation (Hx) selon l'une quelconque des revendications 1 à 6, **caractérisé en ce que** le message d'état peut être fourni à des intervalles de temps prédéfinis par un microprocesseur d'appareil de régulation associé à l'appareil de régulation (DUT), au moyen d'un code de régulation exécutable sur le microprocesseur d'appareil de régulation.

8. Appareil de simulation (Hx) selon l'une quelconque des revendications 1 à 7, **caractérisé en ce qu'**une connexion de signal supplémentaire peut être ou est établie de l'unité de calcul (Cx) du dispositif de simulation (Hx) vers un microprocesseur d'appareil de régulation compris dans l'appareil de régulation (DUT), afin d'influencer le premier et/ou le deuxième et/ou le troisième signal de commande de commutation (Ts1, Ts2, Ts3) en fonction d'informations transmises via la connexion de signal supplémentaire du microprocesseur d'appareil de régulation à l'unité de calcul (Cx).

9. Dispositif de simulation (Hx) selon la revendication 8, **caractérisé en ce que** dans le premier moyen de réglage (S1), le troisième potentiel d'alimentation (U3) présente une valeur de tension positive en référence au premier potentiel de référence (GND1), et le premier potentiel d'alimentation (U1) présente une valeur de tension négative, et les relations de grandeur suivantes s'appliquent en outre :

- le deuxième potentiel d'alimentation (U2) est identique au premier potentiel de référence (GND1), donc U2 = GND1 ;
- le deuxième potentiel d'alimentation (U2) présente en valeur une différence de potentiel identique tant avec le troisième potentiel d'alimentation (U3) qu'avec le premier potentiel d'alimentation (U1), donc |(U3 - U2)| - |(U2 - U1 )| ;
- le deuxième potentiel de référence (GND2) est supérieur au premier potentiel d'alimentation (U1) et inférieur au deuxième potentiel d'alimentation (U2), donc U1 < GND2 < U2 ;
- le quatrième potentiel d'alimentation (Ub1) est supérieur au deuxième potentiel d'alimentation (U2) et inférieur au troisième potentiel d'alimentation (U3), donc U2 < Ub1 < U3 ;
- la différence formée par le quatrième potentiel d'alimentation Ub1 en tant que diminuende et le deuxième potentiel d'alimentation U2 en tant que diminuteur est identique à la différence formée par le deuxième potentiel d'alimentation U2 en tant que diminuende et le deuxième potentiel de référence GND2 en tant que diminuteur, donc Ub1-U2 = U2-GND2.

**Fig. 1a
(Stand der
Technik)**

**Fig. 1b
(Stand der
Technik)**

**Fig. 1c
(Stand der
Technik)**

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010010022 A1

- US 9020798 B2